# EUROPEAN PATENT APPLICATION

(11) **EP 4 561 289 A1**
(43) Date of publication of application: **28.05.2025**
(21) Application number: 24184967.8
(22) Date of filing: 27.06.2024
(51) Int. Cl.: H10B 12/00, H01L 29/786

(54) **SEMICONDUCTOR DEVICE**

(30) Priority: 22.11.2023 KR 20230163645
(71) Applicant: Samsung Electronics Co., Ltd., Suwon-si, Gyeonggi-do 16677 (KR)
(72) Inventor: CHOI, Minjeong, 16677 Suwon-si, Gyeonggi-do (KR); CHO, Hyungki, 16677 Suwon-si, Gyeonggi-do (KR)
(74) Representative: Kuhnen & Wacker Patent- und Rechtsanwaltsbüro PartG mbB

(57) **Abstract**

A semiconductor device includes a substrate (100), a bit line (BL) disposed on the substrate (100), a first insulating pattern (120) disposed on the bit line (BL), a first word line (WL1)disposed on the first insulating pattern (120), a channel pattern (CP) disposed on the bit line (BL) and spaced apart from the word line in a first direction (DR1), a second insulating pattern (140) disposed on the first word line (WL1) and extending in a second direction (DR2), a third insulating pattern (150) disposed on the channel pattern (CP), the channel pattern (CP) including a horizontal portion (CP_H) interposed between the bit line (BL) and the third insulating pattern (150) and a vertical portion (CP_V) interposed between the third insulating pattern (150) and the word line, and a landing pad (LP) connected to the channel pattern (CP) and covering an upper surface of the vertical portion (CP_V) of the channel pattern (CP) and opposite side surfaces of the vertical portion (CP_V).

## Description

### BACKGROUND

### 1. Field

The present disclosure relates to a semiconductor device.

### 2. Description of the Related Art

It is desirable to increase the integration of semiconductor memory devices in order to meet the excellent performance and low price required by consumers. In the case of semiconductor memory devices, an increased degree of integration is particularly required because the degree of integration is an important factor in determining the price of the product.

In the case of two-dimensional or planar semiconductor memory devices, the degree of integration is mainly determined by the area occupied by a unit memory cell, and is therefore greatly affected by the level of fine pattern formation technology. However, since ultra-high-priced equipment is required to refine patterns, the degree of integration of two-dimensional semiconductor memory devices is increasing but is still limited. Accordingly, semiconductor memory devices including vertical channel transistors whose channels extend in a vertical direction have been proposed.

### SUMMARY

The present disclosure provides a semiconductor device with improved reliability and operational characteristics.

According to an aspect of the present disclosure, a semiconductor device includes a substrate, a bit line disposed on the substrate and extending in a first direction, a first insulating pattern disposed on an upper surface of the bit line and extending in a second direction intersecting the first direction, wherein the first direction and the second direction are parallel to an upper surface of the substrate, a first word line disposed on an upper surface of the first insulating pattern and extending in the second direction, a channel pattern disposed on the upper surface of the bit line and spaced apart from the word line in the first direction, a gate insulating pattern disposed between a first side surface of first the word line and the channel pattern, a second insulating pattern disposed on an upper surface of the first word line and extending in the second direction, a third insulating pattern disposed on the channel pattern, wherein the channel pattern includes a horizontal portion and a vertical portion, wherein the horizontal portion extends along the first direction and is interposed between the upper surface of the bit line and a lower surface of the third insulating pattern, wherein the vertical portion extending from the horizontal portion along a third direction and is interposed between a side surface of the third insulating pattern and the word line, and wherein the third direction is perpendicular to the upper surface of the substrate, and a landing pad connected to the channel pattern and covering an upper surface of the vertical portion of the channel pattern and opposite side surfaces of the vertical portion and extending from the upper surface of the vertical portion.

According to an aspect of the present disclosure, a semiconductor device includes a substrate, a bit line disposed on the substrate and extending in a first direction, a first insulating pattern disposed on the bit line and extending in a second direction intersecting the first direction, a first word line disposed on the first insulating pattern and extending in the second direction, a channel pattern spaced apart from the word line in the first direction, a gate insulating pattern disposed between the word line and the channel pattern, a second insulating pattern disposed on the word line and extending in the second direction, a third insulating pattern disposed on the channel pattern, and a landing pad connected to the channel pattern. The landing pad contacts at least three surfaces of the channel pattern.

According to an aspect of the present disclosure, a semiconductor device includes a substrate, a bit line disposed on the substrate and extending in a first direction, and a word line structure disposed on the bit line and extending in a second direction intersecting the first direction. The word line structure includes: a first insulating pattern covering an upper surface of the bit line, a pair of word lines disposed on the first insulating pattern and spaced apart from each other in the first direction, a first gate insulating pattern covering a side surface of each of the pair of word lines, a second insulating pattern covering upper surfaces of the pair of word lines, a channel pattern disposed between adjacent word line structures in the first direction, a second gate insulating pattern disposed between the channel pattern and the word line structure, a third insulating pattern disposed on the channel pattern, and a landing pad connected to the channel pattern. The channel pattern includes: a horizontal portion extending in the first direction along an upper surface of the bit line, and a vertical portion extending from the horizontal portion along the side surfaces of the adjacent word line structures. The landing pad includes: a first portion protruding between the channel pattern and the third insulating pattern, and a second portion protruding between the channel pattern and the second insulating pattern.

According to an aspect of the present disclosure, a contact area between a channel pattern and a landing pad increases, thereby reducing contact resistance and improving operational characteristics of a semiconductor device.

According to an aspect of the present disclosure, interfacial reliability between a channel pattern and a gate insulating pattern may be improved.

### BRIEF DESCRIPTION OF THE DRAWINGS

FIG. 1 illustrates a layout diagram of a semiconductor device according to some embodiments.
FIG. 2 illustrates a cross-sectional view of the semiconductor device of FIG. 1, taken along line A-A'.
FIG. 3 illustrates an enlarged view of "P1" in FIG. 2.
FIG. 4 illustrates an enlarged view of "P2" in FIG. 3.
FIG. 5 to FIG. 10 illustrate cross-sectional views of a semiconductor device according to some embodiments.
FIG. 11 to FIG. 25 illustrate cross-sectional views of a method of manufacturing a semiconductor device according to some embodiments.

### DETAILED DESCRIPTION

The present disclosure will be described more fully hereinafter with reference to the accompanying drawings, in which embodiments of the disclosure are shown. As those skilled in the art would realize, the described embodiments may be modified in various ways, all without departing from the spirit or scope of the present disclosure.

In order to clearly describe the present disclosure, parts or portions that are irrelevant to the description are omitted, and identical or similar constituent elements throughout the specification are denoted by the same reference numerals.

Further, in the drawings, the size and thickness of each element are arbitrarily illustrated for ease of description, and the present disclosure is not necessarily limited to those illustrated in the drawings. In the drawings, the thicknesses of layers, films, panels, regions, areas, etc., are exaggerated for clarity. In the drawings, for ease of description, the thicknesses of some layers and areas are exaggerated.

It will be understood that when an element such as a layer, film, region, or substrate is referred to as being "on" another element, it can be directly on the other element or intervening elements may also be present. In contrast, when an element is referred to as being "directly on" another element, there are no intervening elements present. Further, in the specification, the word "on" or "above" means disposed on or below the object portion, and does not necessarily mean disposed on the upper side of the object portion based on a gravitational direction.

In addition, unless explicitly described to the contrary, the word "comprise" and variations such as "comprises" or "comprising" will be understood to imply the inclusion of stated elements but not the exclusion of any other elements.

Further, throughout the specification, the phrase "in a plan view" or "on a plane" means viewing a target portion from the top, and the phrase "in a cross-sectional view" or "on a cross-section" means viewing a cross-section formed by vertically cutting a target portion from the side.

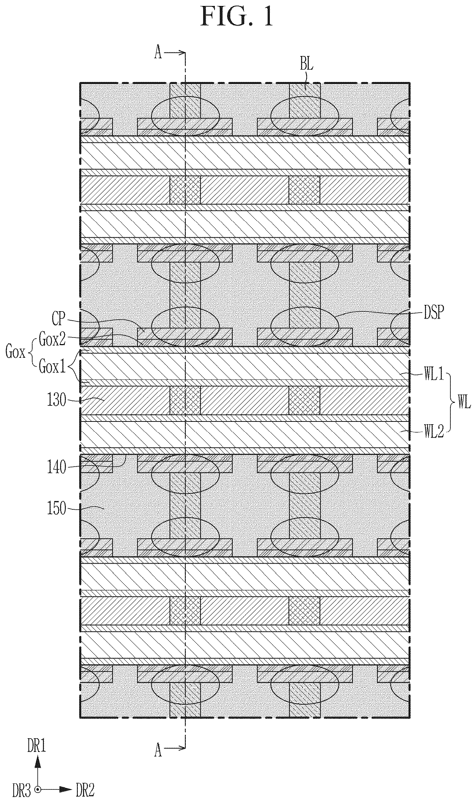

Hereinafter, a semiconductor device according to some embodiments will be described with reference to FIG. 1 to FIG. 4.

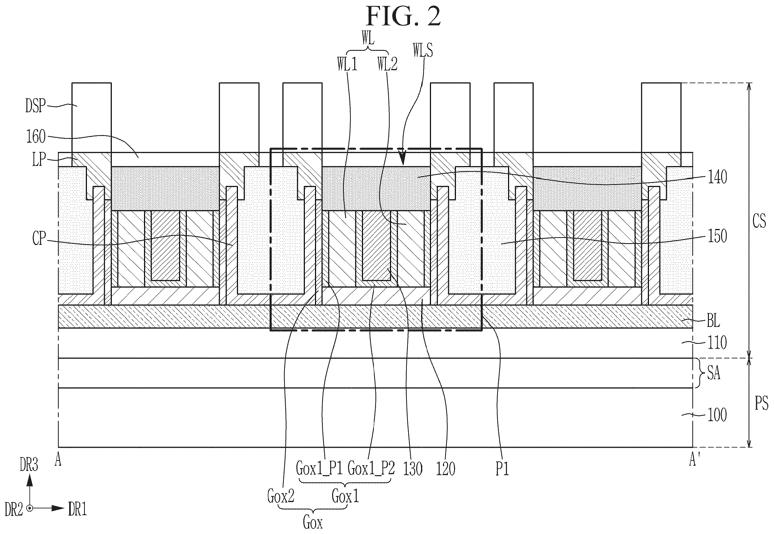

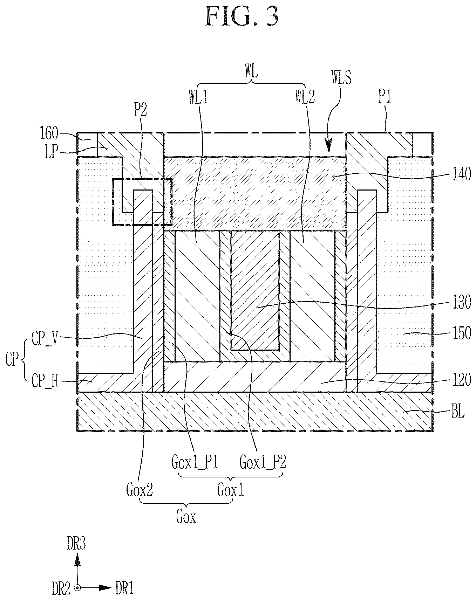

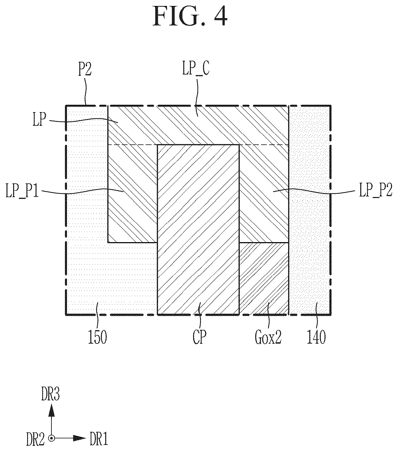

FIG. 1 illustrates a layout diagram of a semiconductor device according to some embodiments. FIG. 2 illustrates a cross-sectional view of the semiconductor device of FIG. 1, taken along line A-A'. FIG. 3 illustrates an enlarged view of "P1" in FIG. 2. FIG. 4 illustrates an enlarged view of "P2" in FIG. 3.

Referring to FIG. 1 to FIG. 4, a semiconductor device according to some embodiments may include a peripheral circuit structure PS and a cell array structure CS disposed on the peripheral circuit structure PS.

The peripheral circuit structure PS may include a substrate 100, and a core and peripheral circuits SA integrated on an upper surface of the substrate 100. The substrate 100 may have a structure in which a base substrate and an epitaxial layer are stacked, but is not limited thereto. For example, the substrate 100 may be a silicon substrate, a gallium arsenic substrate, a silicon germanium substrate, or a semiconductor on insulator (SOI) substrate. Hereinafter, the substrate 100 will be described as a silicon substrate.

The core and peripheral circuits SA may include NMOS and PMOS transistors integrated on the substrate 100. The core and peripheral circuits SA may be electrically connected to bit lines BL through peripheral circuit wires and peripheral circuit contact plugs. Sense amplifiers in the core and peripheral circuits SA may be electrically connected to the bit lines BL, and each sense amplifier may amplify and output a difference in voltage levels sensed by a pair of bit lines BL.

The cell array structure CS may include memory cells including a vertical channel transistor (VCT). The vertical channel transistor may refer to a structure in which the channel length extends in a direction perpendicular to the upper surface of the substrate 100.

In some embodiments, the cell array structure CS may include a lower insulating layer 110, bit lines BL, first insulating patterns 120, channel patterns CP, word lines WL, gate insulating patterns Gox, low dielectric constant material patterns 130 (i.e., low-k material patterns), second insulating patterns 140, third insulating patterns 150, landing pads LP, an interlayer insulating layer 160, and data storage patterns DSP.

The lower insulating layer 110 may cover the core and peripheral circuits SA, the peripheral circuit wires, and the peripheral circuit contact plugs on the substrate 100. The lower insulating layer 110 may include multi-layered insulating films. For example, the lower insulating layer 110 may include or may be a silicon oxide film, a silicon nitride film, a silicon oxynitride film, and/or a low dielectric film.

The bit line BL may be disposed on the substrate 100. For example, the lower insulating layer 110 may be disposed on the substrate 100, and the bit line BL may be disposed on the lower insulating layer 110. The bit line BL may extend along a first direction DR1. The bit lines BL may be disposed to be spaced apart from each other in a second direction DR2 that intersects the first direction DR1. For example, the second direction DR2 may be a direction perpendicular to the first direction DR1. In some embodiments, the first direction DR1 and the second direction DR2 may be parallel to an upper surface of the substrate 100. The lower insulating layer 110 may be disposed to fill a space between the bit lines BL. For example, the upper surface of the lower insulating layer 110 and the upper surface of the bit line BL may be disposed at substantially the same level. Terms such as "same," "equal," "planar," or "coplanar," as used herein encompass near identicality including variations that may occur, for example, due to manufacturing processes. The term "substantially" may be used herein to emphasize this meaning, unless the context or other statements indicate otherwise.

The bit line BL may include or may be formed of doped polysilicon, metal, a conductive metal nitride, a conductive metal silicide, a conductive metal oxide, or a combination thereof. For example, the bit lines BL may include or may be formed of Al, Cu, Ti, Ta, Ru, W, Mo, Pt, Ni, Co, TiN, TaN, WN, NbN, TiAlN, TiSi, TiSiN, TaSi, TaSiN, RuTiN, NiSi, CoSi, IrOx, RuOx, or a combination thereof, but is not limited thereto. The bit line BL may include a single layer or a multilayer made of the above-described materials.

In some embodiments, the bit line BL may include a two-dimensional semiconductor material, and the two-dimensional semiconductor material may include, for example, graphene, carbon nanotube, or a combination thereof.

The first insulating pattern 120 may be disposed on the bit line BL and may extend in the second direction DR2. The first insulating pattern 120 may be disposed to intersect the bit line BL. The first insulating patterns 120 may be disposed to be spaced apart from each other along the first direction DR1.

The first insulating pattern 120 may include or may be formed of, for example, at least one of low dielectric constant (low-k) materials having a dielectric constant smaller than that of a silicon oxide, a silicon oxynitride, a silicon nitride, and a silicon oxide, but is not limited thereto.

The low-k material may include, for example, at least one of polymeric materials of a flowable oxide (FOX), a torene silazene (TOSZ), an undoped silicate glass (USG), a borosilicate glass (BSG), a phosphosilicate glass (PSG), a borophosphosilicate glass (BPSG), a plasma enhanced tetra ethyl ortho silicate (PETEOS), a fluoride silicate glass (FSG), a carbon doped silicon oxide (CDO), xerogel, aerogel, an amorphous fluorinated carbon, an organo silicate glass (OSG), parylene, a bis-benzocyclobutenes (BCB), SiLK, polyimide, a porous polymeric material, and a combination thereof, but is not limited thereto.

The word lines WL are disposed on the first insulating pattern 120, and may extend in the second direction DR2. The word lines WL may be disposed to intersect the bit line BL. The word lines WL may be disposed to be spaced apart along the first direction DR1. The word lines WL may be spaced apart from the bit line BL in a third direction DR3. The third direction DR3 may be a direction perpendicular to the upper surface of the substrate 100, and may be a direction perpendicular to the first and second directions DR1 and DR2. The word lines WL may be spaced apart from the bit line BL in the third direction DR3 by the first insulating pattern 120.

A pair of word lines WL1 and WL2 may be disposed on the first insulating pattern 120. The pair of word lines WL1 and WL2 may be disposed on the upper surface of the first insulating pattern 120. The pair of word lines WL1 and WL2 may include a first word line WL1 and a second word line WL2 spaced apart from each other in the first direction DR1. For example, the first word line WL1 may be disposed near one edge of the upper surface of the first insulating pattern 120, and the second word line WL2 may be disposed near the other edge of the upper surface of the first insulating pattern 120. One side surface of the first word line WL and one side surface of the second word line WL2 may face each other in the first direction DR1.

The word lines WL may include or may be formed of, for example, doped polysilicon, metal, a conductive metal nitride, a conductive metal silicide, a conductive metal oxide, or a combination thereof. The word lines WL may include or may be formed of, for example, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof, but is not limited thereto.

The gate insulating pattern Gox may be disposed between the word line WL and the channel pattern CP to be described later. The gate insulating pattern Gox may be disposed on the side surface of the word line WL. In some embodiments, the gate insulating pattern Gox may include a first gate insulating pattern Gox1 disposed directly on (i.e., contacting) the word line WL and a second gate insulating pattern Gox2 disposed on the first gate insulating pattern Gox1. The first gate insulating pattern Gox1 may be disposed directly on (i.e., contacting) the side surface of the word line WL. The second gate insulating pattern Gox2 may be disposed between the first gate insulating pattern Gox1 and the channel pattern CP to be described later.

The gate insulating pattern Gox may include or may be formed of silicon oxide, silicon oxynitride, a high-k material with a higher dielectric constant than a silicon oxide, or a combination thereof. The high-k material may include a metal oxide or a metal oxynitride. The high-k material may include, for example, HfO₂, HfSiO, HfSiON, HfTaO, HfTiO, HfZrO, ZrO₂, Al₂O₃, or a combination thereof. However, it is not limited thereto, and the material included in the gate insulating pattern Gox may be variously changed.

For example, the first gate insulating pattern Gox1 may be Al₂O₃, and the second gate insulating pattern Gox2 may be SiO₂, but they are not limited thereto.

The first gate insulating pattern Gox1 may be disposed on the first insulating pattern 120. The first gate insulating pattern Gox1 may be disposed on the upper surface of the first insulating pattern 120. In some embodiments, the first gate insulating pattern Gox1 may include a first portion Gox1_P1 covering the side surfaces of the first word line WL1 and the second word line WL2 facing the channel pattern CP to be described later, and a second portion Gox1_P2 covering the side surfaces of the first word line WL1 and the second word line WL2 facing each other.

The second portion Gox1_P2 of the first gate insulating pattern Gox1 may cover the upper surface of the first insulating pattern 120 exposed between the first word line WL1 and the second word line WL2. The second portion Gox1_P2 of the first gate insulating pattern Gox1 conformally cover the side surfaces of the first word line WL1 and the second word line WL2 facing each other and the upper surface of the first insulating pattern 120.

The second gate insulating pattern Gox2 will be described in more detail later.

The second insulating pattern 140 is disposed on the word line WL, and may extend in the second direction DR2. The second insulating pattern 140 may be disposed to intersect the bit line BL. The second insulating patterns 140 may be disposed to be spaced apart from each other along the first direction DR1. The second insulating patterns 140 may overlap the first insulating patterns 120 in the third direction DR3.

The second insulating pattern 140 may include or may be formed of the same material as the first insulating pattern 120, but is not limited thereto. For example, the second insulating pattern 140 may include or may be formed of at least one of low-k materials having a dielectric constant smaller than that of silicon oxide, silicon oxynitride, silicon nitride, or silicon oxide.

The second insulating pattern 140 may be disposed on the pair of word lines WL1 and WL2 and the first gate insulating pattern Gox1 covering the side surfaces of the pair of word lines WL1 and WL2. The second insulating pattern 140 may be disposed on the upper surfaces of the first word line WL1, the second word line WL2, and the first gate insulating pattern Gox1.

The first word line WL1 and the second word line WL2 may be disposed between the first insulating pattern 120 and the second insulating pattern 140. The first word line WL1 and the second word line WL2 may be disposed between the upper surface of the first insulating pattern 120 and the lower surface of the second insulating pattern 140. The first word line WL1 may connect one portion of the upper surface of the first insulating pattern 120 and one portion of the lower surface of the second insulating pattern 140. The second word line WL2 may connect the other portion of the upper surface of the first insulating pattern 120 and the other portion of the lower surface of the second insulating pattern 140. In some embodiments, the first word line WL1 may contact a first portion of the upper surface of the first insulating pattern 120 and a first portion of the lower surface of the second insulating pattern 140. The second word line WL2 may contact a second portion of the upper surface of the first insulating pattern 120 and the second portion of the lower surface of the second insulating pattern 140. For example, the first word line WL1 and the second word line WL2 that are spaced apart from each other in the first direction DR1 may be disposed between the upper surface of the first insulating pattern 120 and the lower surface of the second insulating pattern 140.

The low-k material pattern 130 may be disposed in a space surrounded by an upper surface of the first insulating pattern 120, a lower surface of the second insulating pattern 140, and side surfaces of the first word line WL 1 and the second word line WL2 facing each other. In some embodiments, between the low-k material pattern 130 and the first word line WL1, between the low-k material pattern 130 and the second word line WL2, and between the low-k material pattern 130 and the first insulating pattern 120, the first gate insulating pattern Gox1 may be disposed.

The first gate insulating pattern Gox1 may include the first portion Gox1_P1 covering the side surfaces of the first word line WL1 and the second word line WL2 facing the channel pattern CP to be described later, and the second portion Gox1_P2 covering the side surfaces of the first word line WL1 and the second word line WL2 facing each other.

In some embodiments, the space between the second portion Gox1_P2 of the first gate insulating pattern Gox1 and the second insulating pattern 140 may be filled with a low-k material. The low-k material filled in the space between the second portion Gox1_P2 of the first gate insulating pattern Gox1 and the second insulating pattern 140 may be referred to as the low-k material pattern 130. The low-k material pattern 130 may be disposed on the second portion Gox1_P2 of the first gate insulating pattern Gox1, and the second insulating pattern 140 may be disposed on the low-k material pattern 130.

In some embodiments, the second insulating pattern 140 may cover the upper surfaces of the first word line WL1, the second word line WL2, the first gate insulating pattern Gox1, and the low-k material pattern 130. The lower surface of the second insulating pattern 140 may be disposed at substantially the same level as the upper surfaces of the first word line WL1, the second word line WL2, the first gate insulating pattern Gox1, and the low-k material pattern 130.

A structure including the first insulating pattern 120 described above, the pair of word lines WL1 and WL2 disposed on the first insulating pattern 120, the first gate insulating pattern Gox1 covering the side surfaces of the pair of word lines WL1 and WL2, and the second insulating pattern 140 covering the upper surfaces of the pair of word lines WL1 and WL2 may be referred to as a word line structure WLS hereinafter.

The channel pattern CP may be disposed between the word line structures WLS adjacent to each other in the first direction DR1. A plurality of channel patterns CP may be alternately arranged with a plurality of word line structures WLS in the first direction DR1.

The channel pattern CP may cover the upper surface of the bit line BL exposed between the side surfaces facing each other and the adjacent word line structures WLS. The channel pattern CP may have a conformal shape. The channel pattern CP may cover the upper surface of the bit line BL and the side surfaces of the adjacent word line structures WLS facing each other with a predetermined thickness.

The channel pattern CP may have an approximately "U" shape on a cross-sectional view taken along the first and third directions DR1 and DR3. Specifically, referring to FIG. 3, the channel pattern CP may include a horizontal portion CP_H extending in the first direction DR1 along the upper surface of the bit line BL and a vertical portion CP_V extending along the side surfaces of the word line structures WLS adjacent to the horizontal portion CP_H.

The channel pattern CP may overlap the word lines WL in the first direction DR1, but may not overlap them in the third direction DR3. The channel pattern CP may not be disposed between the lower surfaces of the word lines WL and the upper surface of the bit line BL.

The second gate insulating pattern Gox2 may be disposed between the channel pattern CP and the side surface of the word line structure WLS. The second gate insulating pattern Gox2 may be disposed on the bit line BL exposed between the adjacent word line structures WLS. The second gate insulating pattern Gox2 may extend from the upper surface of the bit line BL in the third direction DR3. The second gate insulating pattern Gox2 may extend in the third direction DR3 to cover the side surface of the word line structure WLS from the upper surface of the bit line BL.

The side surface of the word line structure WLS may include a side surface of the first insulating pattern 120, a side surface of the first gate insulating pattern Gox1, and a side surface of the second insulating pattern 140. The second gate insulating pattern Gox2 may extend in the third direction DR3 to cover the side surface of the first insulating pattern 120, the side surface of the first gate insulating pattern Gox1, and the side surface of the second insulating pattern 140.

In some embodiments, the upper surface of the second gate insulating pattern Gox2 may be disposed at substantially the same level as or a higher level than the upper surface of the first gate insulating pattern Gox1. The upper surface of the second gate insulating pattern Gox2 may be disposed at a lower level than the upper surface of the second insulating pattern 140.

The channel pattern CP may extend in a direction parallel to the substrate 100 to cover the upper surface of the bit line BL. The channel pattern CP may extend in a direction perpendicular to the substrate 100 to cover the side surface of the first insulating pattern 120, the side surface of the gate insulating pattern Gox, and the side surface of the second insulating pattern 140. In some embodiments, the vertical portion CP_V of the channel pattern CP may extend from the upper surface of the bit line BL onto the side surface of the second gate insulating pattern Gox2. The channel pattern CP may extend in the third direction DR3 to cover the side surface of the first insulating pattern 120, the side surface of the first gate insulating pattern Gox1, and the side surface of the second insulating pattern 140 with the second gate insulating pattern Gox2 interposed therebetween. The upper surface of the vertical portion CP_V of the channel pattern CP may be disposed at a higher level than the upper surface of the second gate insulating pattern Gox2.

The channel pattern CP may be in contact with the upper surface of the bit line BL. The horizontal portion CP_H of the channel pattern CP may be in contact with the upper surface of the bit line BL. The channel pattern CP may be in contact with the landing pad LP, which will be described later. The vertical portion CP_V of the channel pattern CP may be in contact with the landing pad LP. The term "contact," or "in contact with" as used herein, refers to a direct connection (i.e., physical touching) unless the context indicates otherwise.

The channel pattern CP may include a first source/drain area and a second source/drain area. For example, the horizontal portion CP_H of the channel pattern CP may be connected to the bit line BL to function as the first source/drain area, the vertical portion CP_V of the channel pattern CP may be connected to the landing pad LP to function as the second source/drain region, and a portion of the channel pattern CP between the first source/drain area and the second source/drain area may function as a channel area.

The channel pattern CP may include or may be formed of an oxide semiconductor material. The oxide semiconductor material may be a combination of at least two or more of In, Ga, Zn, Al, Sn, and Hf, but is not limited thereto. The oxide semiconductor material may further include a material such as Si, Mg, Ta, La, Nd, Ce, Sc, Cr, Co, Nb, Mo, Ba, Gd, Ti, W, Pd, Ru, Ni, and Mn to the above composition.

For example, the channel pattern CP may include or may be formed of an indium gallium zinc oxide (IGZO), an indium tin zinc oxide (ITZO), an indium zinc oxide (IZO), a zinc oxide (ZnO), a zinc tin oxide (ZTO), a zinc oxynitride (ZnON), a zirconium zinc tin oxide (ZZTO), a tin oxide (SnO), a hafnium indium zinc oxide (HIZO), a gallium zinc tin oxide (GZTO), an aluminum zinc tin oxide (AZTO), a ytterbium gallium zinc oxide (YGZO), an indium gallium oxide (IGO), or a combination thereof. However, the present disclosure is not limited thereto, and the oxide semiconductor material included in the channel pattern CP may be variously changed.

A third insulating pattern 150 may be disposed on the channel pattern CP. The third insulating pattern 150 may fill the inside of the space surrounded by the U-shaped channel pattern CP. The horizontal portion CP_H of the channel pattern CP may extend in the first direction DR1 between the bit line BL and the third insulating pattern 150. The vertical portion CP_V of the channel pattern CP may extend in the third direction DR3 between the third insulating pattern 150 and the word line WL from the horizontal portion CP_H.

The third insulating pattern 150 may extend in the second direction DR2. The third insulating patterns 150 may be disposed to be spaced apart from each other in the first direction DR1. Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first" in a particular claim) may be described elsewhere with a different ordinal number (e.g., "second" in the specification or another claim).

The third insulating pattern 150 may include or may be formed of a material having the same or similar etch selectivity as that of the second gate insulating pattern Gox2. For example, the third insulating pattern 150 may include or may be formed of at least one of low-k materials having a dielectric constant smaller than that of silicon oxide, silicon oxynitride, silicon nitride, or silicon oxide.

The upper surface of the third insulating pattern 150 adjacent to the vertical portion CP_V of the channel pattern CP may be disposed at a lower level than the upper surface of the vertical portion CP_V of the channel pattern CP. In some embodiments, the upper surface of the third insulating pattern 150 may be disposed at a substantially equivalent or higher level than the upper surface of the second insulating pattern 140.

The landing pad LP may be connected to the channel pattern CP. The channel pattern CP may include at least three surfaces that are in contact with the landing pad LP. The landing pad LP may cover an upper surface of the channel pattern CP and opposite side surfaces extending from the upper surface. Specifically, the landing pad LP may cover an upper surface of the vertical portion CP_V of the channel pattern CP and opposite side surfaces extending from the upper surface. The channel pattern CP described below with reference to FIG. 4 may be the vertical portion CP_V of the channel pattern CP.

Referring to FIG. 4, the landing pad LP may include a first portion LP_P1 disposed between the third insulating pattern 150 and the channel pattern CP, a second portion LP_P2 disposed between the channel pattern CP and the second insulating pattern 140, and a connection portion LP_C connecting the first portion LP_P1 to the second portion LP_P2 and covering the upper surface of the channel pattern CP.

The first portion LP_P1 and the second portion LP_P2 of the landing pad LP may be in contact with the side surfaces of the channel pattern CP facing each other in the first direction DR1, respectively. The first portion LP_P1 of the landing pad LP may be in contact with one side surface of the channel pattern CP, and the second portion LP_P2 of the landing pad LP may be in contact with the other side surface of the channel pattern CP. The connection portion LP_C of the landing pad LP may connect the first portion LP_P1 to the second portion LP_P2. The connection portion LP_C of the landing pad LP may be in contact with the upper surface of the channel pattern CP.

The first portion LP_P1 of the landing pad LP may protrude from the lower surface of the connection portion LP_C of the landing pad LP between the channel pattern CP and the third insulating pattern 150. The second portion LP_P2 of the landing pad LP may protrude from the lower surface of the connection portion LP_C of the landing pad LP between the channel pattern CP and the second insulating pattern 140. The lower surface of the connection portion LP_C of the landing pad LP may be disposed at substantially the same level as the upper surface of the channel pattern CP.

The lower surface of the first portion LP_P1 of the landing pad LP may be in contact with the third insulating pattern 150. The lower surface of the second portion LP_P2 of the landing pad LP may be in contact with the gate insulating pattern Gox. The second portion LP_P2 of the landing pad LP may be in contact with the second gate insulating pattern Gox2. The second portion LP_P2 of the landing pad LP may cover the upper surface of the second gate insulating pattern Gox2.

Although FIG. 4 illustrates that the first portion LP_P1 of the landing pad LP and the second portion LP_P2 of the landing pad LP have substantially the same length in the third direction DR3, the present disclosure is not limited thereto. For example, the length of the first portion LP_P1 in the third direction DR3 may be longer than the length of the second portion LP_P2 in the third direction DR3. The height of the upper surface of the third insulating pattern 150 adjacent to the channel pattern CP may be lower than the height of the upper surface of the second gate insulating pattern Gox2.

The landing pad LP may extend above the upper surface of the third insulating pattern 150. The width (length in the first direction DR1) of the upper surface of the landing pad LP may be greater than the width of the landing pad LP between the second insulating pattern 140 and the third insulating pattern 150. However, the present disclosure is not limited thereto, and for example, the width (length in the first direction DR1) of the upper surface of the landing pad LP may be substantially the same as the width of the landing pad LP between the second insulating pattern 140 and the third insulating pattern 150.

FIG. 1 to FIG. 3 illustrate that the connection portion LP_C of the landing pad LP does not extend above the upper surface of the second insulating pattern 140, but the present disclosure is not limited thereto.

The landing pad LP may include or may be formed of doped polysilicon, metal, a conductive metal nitride, a conductive metal oxide, or a combination thereof. For example, the landing pad LP may include or may be formed of Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof, but is not limited thereto.

The interlayer insulating layer 160 may fill a space between the landing pads LPs spaced apart from each other in the first direction DR1 on the second insulating pattern 140 and the third insulating pattern 150. For example, the lower surface of the interlayer insulating layer 160 may be disposed at substantially the same level as the lower surface of the portions of the landing pads LP extending above the upper surface of the third insulating pattern 150, but is not limited thereto.

The data storage patterns DSP may be disposed on the landing pad LP, respectively. The data storage patterns DSP may be electrically connected to the channel pattern CP through the landing pad LP, respectively. As shown in FIG. 1, the data storage patterns DSP may be arranged in a matrix form along the first direction DR1 and the second direction DR2.

In some embodiment, the data storage pattern DSP may be a capacitor, and may include lower and upper electrodes and a capacitor dielectric film interposed therebetween. When the data storage pattern DSP is the capacitor, the lower electrode may be in contact with the landing pad LP, and the lower electrode may have various shapes such as circular, elliptical, rectangular, square, rhombus, and hexagonal shapes in a plan view.

Alternatively, the data storage pattern DSP may be a variable resistance pattern that may be switched into two resistance states by an electrical pulse applied to a memory element. For example, the data storage pattern DSP may include a phase-change material whose crystal state changes depending on an amount of current, a perovskite compound, a transition metal oxide, a magnetic material, a ferromagnetic material, or an antiferromagnetic material.

The semiconductor device according to some embodiments may include the second gate insulating pattern Gox2 disposed between the first gate insulating pattern Gox1 and the channel pattern CP. Since the first gate insulating pattern Gox1 and the channel pattern CP are not in direct contact with each other by the second gate insulating pattern Gox2, reliability of an interface between the channel pattern CP and the gate insulating pattern Gox may be improved.

The semiconductor device according to some embodiments includes the first gate insulating pattern Gox1 that includes or is formed of Al₂O₃ and the second gate insulating pattern Gox2 the includes or is formed of SiO₂, thereby reducing the interface trap density and leakage current of the channel pattern CP to improve reliability.

The semiconductor device according to some embodiments may include the channel pattern CP and the landing pad LP whose at least three surfaces contact each other. According to a comparative example, the landing pad LP may contact only the upper surface of the channel pattern CP. According to some embodiments, the landing pad LP may cover the upper surface of the channel pattern CP and opposite side surfaces extending from the upper surface. Accordingly, the contact area between the channel pattern CP and the landing pad LP increases, so that contact resistance may decrease and operation characteristics of the semiconductor device may be improved.

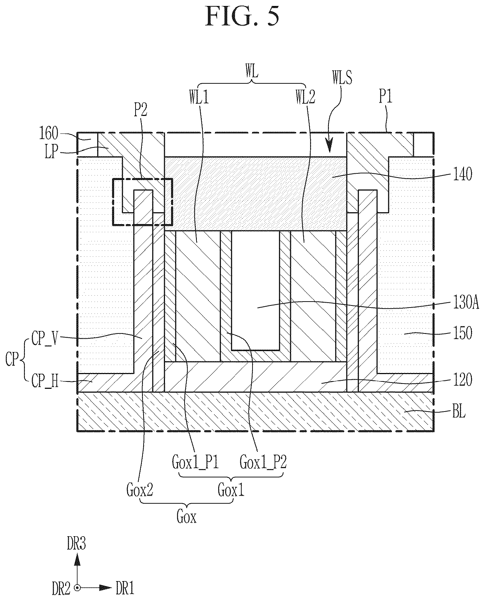

Hereinafter, a semiconductor device according to some embodiments will be described with reference to FIG. 5 to FIG. 10. In the following embodiments, the same components as the above-described embodiments are referred to by the same reference numerals, duplicate descriptions are omitted or simplified, and differences are mainly explained.

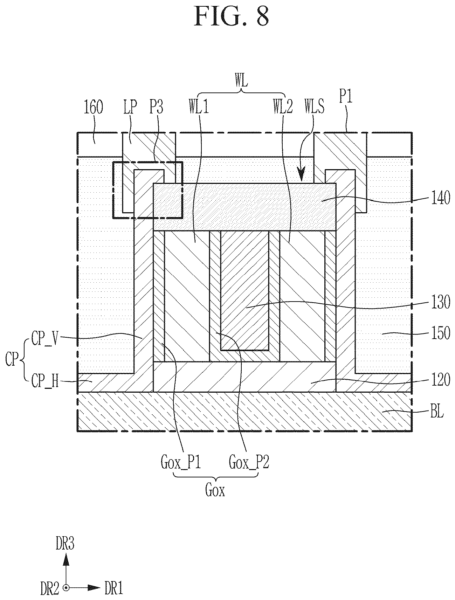

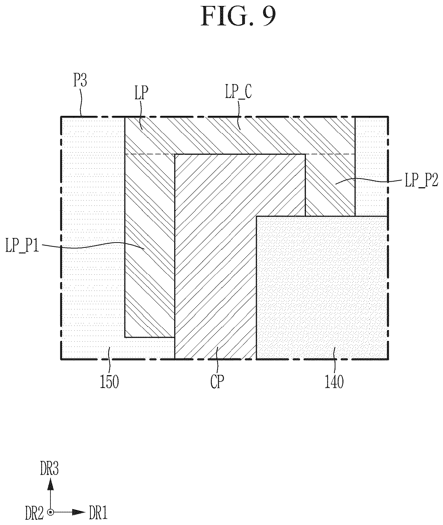

FIG. 5 to FIG. 10 illustrate cross-sectional views of a semiconductor device according to some embodiments. FIG. 5, FIG. 6, FIG. 7, FIG. 8, and FIG. 10 illustrate enlarged views of an area corresponding to "P1" of FIG. 2. FIG. 9 illustrates an enlarged view of "P3" in FIG. 8.

Referring to FIG. 5, unlike the embodiments of FIG. 1 to FIG. 4, an air gap 130A may be disposed in a space surrounded by the upper surface of the first insulating pattern 120, the lower surface of the second insulating pattern 140, and the side surfaces of the first word line WL1 and the second word line WL2 facing each other. According to some embodiments, the air gap 130A may be disposed in a space between the second portion Gox1_P2 of the first gate insulating pattern Gox1 and the second insulating pattern 140. The air gap 130A may be disposed on the second portion Gox1_P2 of the first gate insulating pattern Gox1, and the second insulating pattern 140 may be disposed on the air gap 130A.

The first gate insulating pattern Gox1 may be disposed between the air gap 130A and the first word line WL1, between the air gap 130A and the second word line WL2, and between the air gap 130A and the first insulating pattern 120.

In FIG. 5, only the low-k material pattern 130 of FIG. 1 to FIG. 4 is changed to the air gap 130A, and the remaining components may be the same.

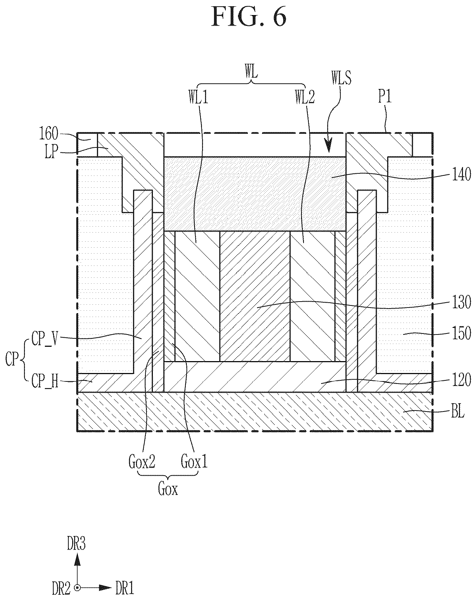

In FIG. 6, unlike the embodiment of FIG. 1 to FIG. 4, the first gate insulating pattern Gox1 may cover only side surfaces facing the channel pattern CP among opposite side surfaces of the first word line WL 1 and the second word line WL2. In FIG. 6, the first gate insulating pattern Gox1 may include only the first portion Gox1_P1 of FIG. 1 to FIG. 4, and the first gate insulating pattern Gox1 may not include the second portion Gox1_P2 of FIG. 1 to FIG. 4.

According to some embodiments, a space defined by an upper surface of the first insulating pattern 120, a lower surface of the second insulating pattern 140, and side surfaces of the first word line WL1 and the second word line WL2 facing each other may be filled with a low-k material. In the embodiment of FIG. 6, the low-k material filled in the space surrounded by the upper surface of the first insulating pattern 120, the lower surface of the second insulating pattern 140, and the side surfaces of the first word line WL 1 and the second word line WL2 facing each other may be referred to as the low-k material pattern 130. The low-k material pattern 130 may be in contact with the side surfaces of the first word line WL1 and the second word line WL2, facing each other. The low-k material pattern 130 may be in contact with the upper surface of the first insulating pattern 120.

In the embodiment of FIG. 6, only the structure of the first gate insulating pattern Gox1 of the embodiment of FIG. 1 to FIG. 4 is partially changed, and the remaining components may be the same.

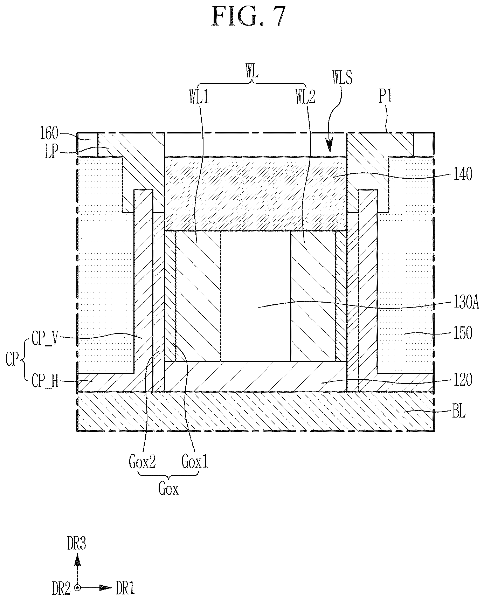

In FIG. 7, unlike the embodiment of FIG. 1 to FIG. 4, the first gate insulating pattern Gox1 may cover only side surfaces facing the channel pattern CP among opposite side surfaces of the first word line WL1 and the second word line WL2. In the embodiment of FIG. 7, the first gate insulating pattern Gox1 may include only the first portion Gox1_P1 of FIG. 1 to FIG. 4. In the embodiment of FIG. 7, the first gate insulating pattern Gox1 may not include the second portion Gox1_P2 of FIG. 1 to FIG. 4.

According to some embodiments, the air gap 130A may be disposed in the space defined by the upper surface of the first insulating pattern 120, the lower surface of the second insulating pattern 140, and the side surfaces of the first word line WL 1 and the second word line WL2 facing each other. The air gap 130A may be disposed in the space surrounded by the upper surface of the first insulating pattern 120, the lower surface of the second insulating pattern 140, and the side surfaces of the first word line WL 1 and the second word line WL2 facing each other.

In the embodiment of FIG. 7, only the low-k material pattern 130 of the embodiment of FIG. 6 is changed to the air gap 130A, and the remaining components may be the same.

Referring to FIG. 8 and FIG. 9, the first insulating pattern 120 may be disposed on the bit line BL extending along the first direction DR1. The first insulating pattern 120 may extend in the second direction DR2 intersecting the first direction DR1. A pair of word lines WL1 and WL2 extending in the second direction DR2 may be disposed on the first insulating pattern 120. The first word line WL1 and the second word line WL2 may be disposed to be spaced apart from each other in the first direction DR1 on the first insulating pattern 120. One side surface of the first word line WL and one side surface of the second word line WL2 may face each other in the first direction DR1.

The gate insulating pattern Gox may be disposed on the side surface of the first word line WL1 and the side surface of the second word line WL2. The gate insulating pattern Gox may include a first portion Gox_P1 disposed on side surfaces of the first word line WL1 and the second word line WL2 facing the channel pattern CP, and a second portion Gox_P2 disposed on side surfaces of the first word line WL 1 and the second word line WL2 facing each other. The first portion Gox_P1 may be disposed between the first word line WL1 and the channel pattern CP, and between the second word line WL2 and the channel pattern CP. The second portion Gox_P2 may be disposed between the first word line WL1 and the second word line WL2.

The first portion Gox_P1 may cover side surfaces of the first word line WL1 and the second word line WL2 facing the channel pattern CP. The second portion Gox_P2 may cover side surfaces of the first word line WL1 and the second word line WL2 facing each other, and an upper surface of the first insulating pattern 120 exposed between the first word line WL1 and the second word line WL2. The second portion Gox_P2 may conformally cover the side surfaces of the first word line WL 1 and the second word line WL2 facing each other, and the upper surface of the first insulating pattern 120 exposed between the side surfaces.

For example, the gate insulating pattern Gox may be Al₂O₃, but is not limited thereto.

The upper surface of the gate insulating pattern Gox may be disposed at the same level as the upper surfaces of the first word line WL 1 and the second word line WL2. The low-k material pattern 130 may be disposed on the second portion Gox_P2 of the gate insulating pattern Gox. The low-k material pattern 130 may be disposed on the second portion Gox_P2 of the gate insulating pattern Gox, and the second insulating pattern 140 may be disposed on the low-k material pattern 130. The low-k material pattern 130 may be a low-k material filled in a space between the second portion Gox_P2 of the gate insulating pattern Gox and the second insulating pattern 140. The upper surface of the low-k material pattern 130 may be disposed at the same level as the upper surfaces of the first word line WL1 and the second word line WL2.

The second insulating pattern 140 may be disposed on the upper surfaces of the first word line WL1 and the second word line WL2, the upper surface of the gate insulating pattern Gox, and the upper surface of the low-k material pattern 130. The second insulating pattern 140 may cover the upper surfaces of the first word line WL1 and the second word line WL2, the upper surface of the gate insulating pattern Gox, and the upper surface of the low-k material pattern 130, and may extend in the second direction DR2.

The first word line WL1 and the second word line WL2 may be disposed between the upper surface of the first insulating pattern 120 and the lower surface of the second insulating pattern 140. The first word line WL1 may connect one portion of the upper surface of the first insulating pattern 120 and one portion of the lower surface of the second insulating pattern 140. The second word line WL2 may connect the other portion of the upper surface of the first insulating pattern 120 and the other portion of the lower surface of the second insulating pattern 140.

The low-k material pattern 130 may be disposed in a space surrounded by an upper surface of the first insulating pattern 120, a lower surface of the second insulating pattern 140, and side surfaces of the first word line WL1 and the second word line WL2 facing each other. The second portion Gox_P2 of the gate insulating pattern Gox may be disposed between the low-k material pattern 130 and the first word line WL1, between the low-k material pattern 130 and the second word line WL2, and between the low-k material pattern 130 and the first insulating pattern 120.

A structure including the first insulating pattern 120 described above, the pair of word lines WL1 and WL2 disposed on the first insulating pattern 120, the gate insulating pattern Gox covering the side surfaces of the pair of word lines WL1 and WL2, and the second insulating pattern 140 covering the upper surfaces of the pair of word lines WL1 and WL2 may be referred to as a word line structure WLS hereinafter.

The channel pattern CP may be disposed on the side and upper surfaces of the word line structure WLS. In the embodiment illustrated in FIG. 8 and FIG. 9, unlike the embodiment illustrated in FIG. 1 to FIG. 4, the channel pattern CP may be disposed directly on (i.e., contacting) the side surface of the word line structure WLS.

Each of the word line structures WLS may extend in the second direction DR2. The word line structures WLS may be disposed to be spaced apart from each other in the first direction DR1. The channel pattern CP may be disposed between adjacent word line structures WLS.

The horizontal portion CP_H of the channel pattern CP may cover the upper surface of the bit line BL between adjacent word line structures WLS. The horizontal portion CP_H of the channel pattern CP may be in contact with the bit line BL, and may be electrically connected to the bit line BL. The vertical portion CP_V of the channel pattern CP may extend from the upper surface of the bit line BL in the third direction DR3 along the side surface of the word line structure WLS. The vertical portion CP_V of the channel pattern CP may extend from the upper surface of the bit line BL in the third direction DR3 to cover the side surface of the first insulating pattern 120, the side surface of the first portion Gox_P1 of the gate insulating pattern Gox, and the side surface of the second insulating pattern 140. The vertical portion CP_V of the channel pattern CP may be spaced apart from the first word line WL 1 and the second word line WL2 by the first portion Gox_P1 of the gate insulating pattern Gox.

In the embodiment illustrated in FIG. 8 and FIG. 9, unlike the embodiment illustrated in FIG. 1 to FIG. 4, the vertical portion CP_V of the channel pattern CP may be disposed directly above the side surface of the first insulating pattern 120 and the side surface of the second insulating pattern 140. The gate insulating pattern Gox disposed between the vertical portion CP_V of the channel pattern CP and the word lines WL may include one type of material. In the embodiment illustrated in FIG. 8 and FIG. 9, only the gate insulating pattern (the first gate insulating pattern Gox1 of FIG. 1 to FIG. 4) including Al₂O₃ may exist between the vertical portion CP_V of the channel pattern CP and the word lines WL, and the gate insulating pattern (the second gate insulating pattern Gox2 of FIG. 1 to FIG. 4) including SiO₂ may not exist. In the embodiment illustrated in FIG. 8 and FIG. 9, the vertical portion CP_V of the channel pattern CP may be disposed directly on (i.e., contacting) the gate insulating pattern (the first gate insulating pattern Gox1 of FIG. 1 to FIG. 4) including Al₂O₃.

In the embodiment illustrated in FIG. 8 and FIG. 9, unlike the embodiment illustrated in FIG. 1 to FIG. 4, the channel pattern CP may further extend to cover the upper surface of the word line structure WLS. The channel pattern CP may further extend to cover the upper surface of the second insulating pattern 140. The channel pattern CP may cover a portion of the upper surface of the second insulating pattern 140 adjacent to the side surface of the second insulating pattern 140. The upper surface of the channel pattern CP may be disposed at a higher level than the upper surface of the second insulating pattern 140.

The channel pattern CP may have a conformal shape. The channel pattern CP may conformally cover the upper surface of the bit line BL, the side surface of the first insulating pattern 120, the side surface of the first portion Gox_P1 of the gate insulating pattern Gox, and the side surface and the upper surface of the second insulating pattern 140.

In some embodiments, the channel pattern CP may include or may be formed of an oxide semiconductor such as IGZO, but is not limited thereto.

The third insulating pattern 150 may be disposed on the channel pattern CP. The third insulating pattern 150 may be disposed between adjacent word line structures WLS. The lower surface and opposite side surfaces of the third insulating pattern 150 between the adjacent word line structures WLS may be surrounded by the channel pattern CP.

In some embodiments illustrated in FIG. 8 and FIG. 9, unlike the embodiment illustrated in FIG. 1 to FIG. 4, the third insulating pattern 150 may be further disposed on the word line structures WLS. The third insulating pattern 150 may be further disposed on the second insulating pattern 140. The third insulating pattern 150 may be disposed on the upper surface of the second insulating pattern 140.

In some embodiments, the third insulating pattern 150 may include or may be formed of an insulating material having etch selectivity with respect to the second insulating pattern 140.

The landing pad LP may be connected to the channel pattern CP. In the embodiment illustrated in FIG. 8 and FIG. 9, as in the embodiment illustrated in FIG. 1 to FIG. 4, the landing pad LP may contact at least three surfaces of the channel pattern CP. The landing pad LP includes a first portion LP_P1 and a second portion LP _P2 respectively contacting the side surfaces of the channel pattern CP facing each other in the first direction DR1, and a connection portion LP_C contacting the upper surface of the channel pattern CP. The connection portion LP_C may connect the first portion LP_P1 to the second portion LP_P2.

According to some embodiments illustrated in FIG. 8 and FIG. 9, the first portion LP_P1 and the second portion LP_P2 of the landing pad LP may be disposed between the third insulating pattern 150 and the channel pattern CP. The connection portion LP_C of the landing pad LP may connect the first portion LP_P1 and the second portion LP_P2 to cover the upper surface of the channel pattern CP. The lower surface of the connection portion LP_C of the landing pad LP may be disposed at substantially the same level as the upper surface of the channel pattern CP.

The first portion LP_P1 of the landing pad LP may protrude from the lower surface of the connection portion LP_C of the landing pad LP between a portion of the third insulating pattern 150 disposed between the adjacent word line structures WLS and the channel pattern CP. The lower surface of the first portion LP_P1 may be in contact with the third insulating pattern 150.

In the embodiment illustrated in FIG. 8 and FIG. 9, unlike the embodiment illustrated in FIG. 1 to FIG. 4, the second portion LP _P2 of the landing pad LP may protrude between the third insulating pattern 150 disposed on the word line structures WLS and the channel pattern CP. The lower surface of the second portion LP_P2 of the landing pad LP may be in contact with the second insulating pattern 140. The lower surface of the second portion LP _P2 of the landing pad LP may be in contact with the upper surface of the second insulating pattern 140.

FIG. 8 and FIG. 9 illustrate that the length of the first portion LP_P1 of the landing pad LP in the third direction DR3 is longer than the length of the second portion LP_P2 of the landing pad LP in the third direction DR3, but the present disclosure is not limited thereto. For example, the length of the first portion LP_P1 in the third direction DR3 may be substantially the same as or shorter than the length of the second portion LP_P2 in the third direction DR3.

FIG. 8 and FIG. 9 illustrate that the width (for example, the length in the first direction DR1) of the connection portion LP_C of the landing pad LP is constant, but the present disclosure is not limited thereto. For example, the landing pad LP may extend above the uppermost surface of the third insulating pattern 150, so that the width of the upper surface of the connection portion LP_C of the landing pad LP may be greater than the width of the connection portion LP_C of the landing pad LP between the third insulating patterns 150.

The landing pads LP may be disposed to be spaced apart from each other in the first direction DR1. Although not shown, the landing pads LP may be disposed to be spaced apart from each other in the second direction DR2. The interlayer insulating layer 160 may fill the space between the landing pads LP on the third insulating pattern 150.

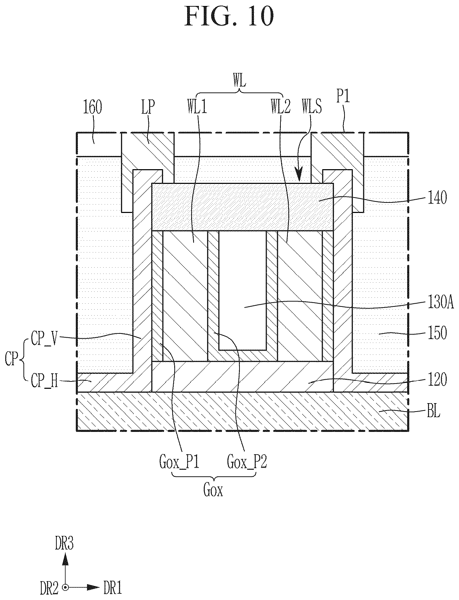

In the embodiment of FIG. 10, only the low-k material pattern 130 of the embodiment of FIG. 8 and FIG. 9 is changed to the air gap 130A, and the remaining components may be the same.

Referring to FIG. 10, unlike the embodiments of FIG. 8 and FIG. 9, an air gap 130A may be disposed in a space surrounded by the upper surface of the first insulating pattern 120, the lower surface of the second insulating pattern 140, and the side surfaces of the first word line WL1 and the second word line WL2 facing each other. According to some embodiments, the air gap 130A may be disposed in a space between the second portion Gox_P2 of the gate insulating pattern Gox and the second insulating pattern 140. The air gap 130A may be disposed on the second portion Gox_P2 of the gate insulating pattern Gox, and the second insulating pattern 140 may be disposed on the air gap 130A.

The gate insulating pattern Gox may be disposed between the air gap 130A and the first word line WL1, between the air gap 130A and the second word line WL2, and between the air gap 130A and the first insulating pattern 120.

The semiconductor device according to the embodiment of FIG. 8 to FIG. 10, like the embodiment illustrated in FIG. 1 to FIG. 4, includes the channel pattern CP and the landing pad LP with at least three surfaces in contact, and the landing pad LP may cover the upper surface of the channel pattern CP and opposite side surfaces extending from the upper surface. Accordingly, the contact area between the channel pattern CP and the landing pad LP increases, so that contact resistance may decrease and operation characteristics of the semiconductor device may be improved.

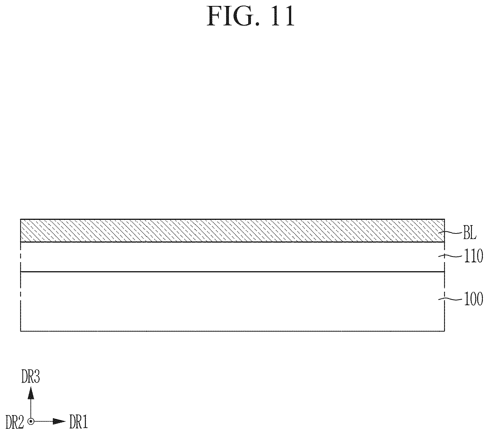

Hereinafter, a method of manufacturing the semiconductor device according to the embodiment illustrated in FIG. 1 to FIG. 4 will be described with reference to FIG. 11 to FIG. 25. In FIG. 11 to FIG. 25, the core and peripheral circuits SA of FIG. 1 to FIG. 4 are omitted for convenience, but the core and peripheral circuits SA may be disposed between the substrate 100 and the lower insulating layer 110.

FIG. 11 to FIG. 25 illustrate cross-sectional views of a method of manufacturing a semiconductor device according to some embodiments.

Referring to FIG. 11, the bit lines BL may be formed on the lower insulating layer 110.

The lower insulating layer 110 may include multi-layered insulating films. For example, the lower insulating layer 110 may include or may be formed of a silicon oxide film, a silicon nitride film, a silicon oxynitride film, and/or a low dielectric film.

The bit lines BL may extend in the first direction DR1, and may be disposed to be spaced apart from each other in the second direction DR2 that intersects the first direction DR1. For example, the second direction DR2 may be a direction perpendicular to the first direction DR1. The bit lines BL may be formed by depositing a conductive layer on the lower insulating layer 110 and then patterning the conductive layer.

Although not shown, an insulating material may fill the space between the bit lines BL, and may include or may be the same insulating material as the lower insulating layer 110, but is not limited thereto. When the insulating material filling the space between the bit lines BL includes or is the same insulating material as the lower insulating layer 110, the insulating material may be integrated with the lower insulating layer 110. For example, the upper surface of the lower insulating layer 110 and the upper surface of the bit line BL may be disposed at substantially the same level.

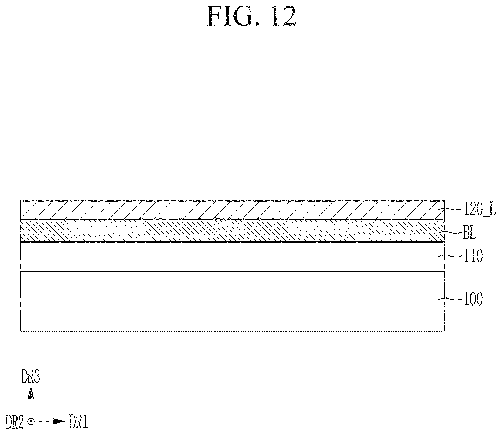

Referring to FIG. 12, a first insulating pattern material layer 120_L may be formed on the bit lines BL and the lower insulating layer 110. The first insulating pattern material layer 120_L may be formed using at least one of physical vapor deposition (PVD), thermal chemical vapor deposition (thermal CVD), low pressure chemical vapor deposition (LP-CVD), plasma enhanced chemical vapor deposition (PE-CVD), and atomic layer deposition (ALD) technologies. However, the method of depositing the first insulating pattern material layer 120_L is not limited thereto, and may be variously changed.

The first insulating pattern material layer 120_L may include or may be formed of at least one of a silicon oxide, a silicon oxynitride, a silicon nitride, and a low-k material having a dielectric constant lower than that of the silicon oxide, but is not limited thereto.

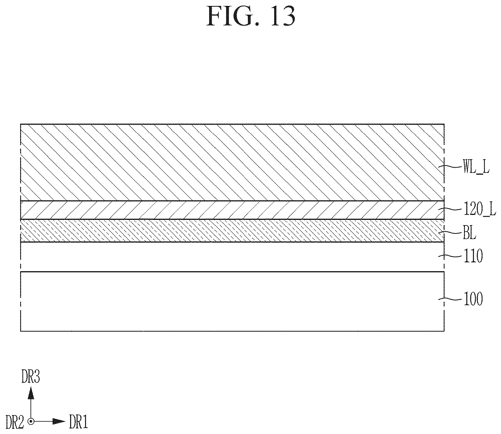

Referring to FIG. 13, a word line material layer WL_L may be formed. The word line material layer WL_L may be deposited through a CVD, PVD, or ALD process, but is not limited thereto.

The word line material layer WL_L may include or may be formed of doped polysilicon, metal, a conductive metal nitride, a conductive metal silicide, a conductive metal oxide, or a combination thereof.

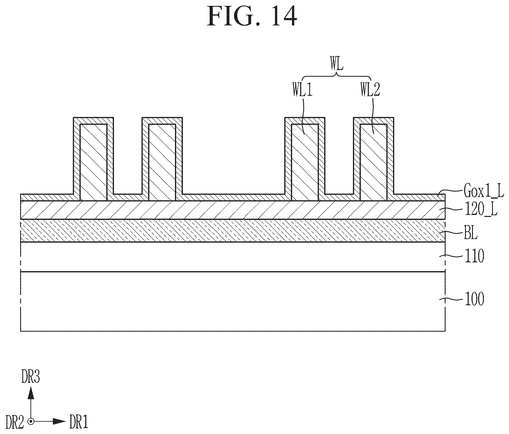

Referring to FIG. 14, the first word lines WL1 and the second word lines WL2 may be formed by patterning the word line material layer WL_L. The first word lines WL1 and the second word lines WL2 may extend in the second direction DR2, and may be spaced apart from each other in the first direction DR1. The first word line WL1 and the second word line WL2 may be alternately disposed.

Next, a first gate insulating pattern material layer Gox1_L may be formed to conformally cover the first word lines WL1 and the second word lines WL2. The first gate insulating pattern material layer Gox1_L may be deposited through a CVD, PVD, or ALD process, but is not limited thereto.

The first gate insulating pattern material layer Gox1_L may include or may be formed of silicon oxide, silicon oxynitride, a high-k material with a higher dielectric constant than silicon oxide, or a combination thereof. The high-k material may include a metal oxide or a metal oxynitride.

In some embodiments, the first gate insulating pattern material layer Gox1_L may include or may be formed of Al₂O₃.

In some embodiments, after the first gate insulating pattern material layer Gox1_L is formed in the process of FIG. 14, patterning for removing a portion of the first gate insulating pattern material layer Gox1_L disposed between side surfaces of a pair of first word line WL1 and second word line WL2 facing each other may be further performed. Subsequently, by performing subsequent processes, the semiconductor device of the embodiment shown in FIG. 6 may be formed.

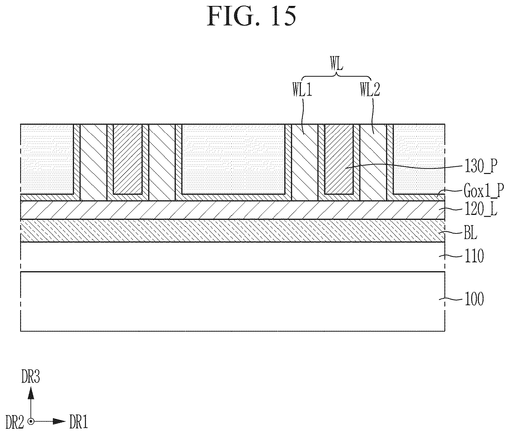

Referring to FIG. 15, a preliminary first gate insulating pattern Gox1_P and a preliminary low-k material pattern 130 _P may be formed.

First, a low-k material layer may be deposited to a thickness that covers the upper surface of the first gate insulating pattern material layer Gox1_L. The low-k material layer may be deposited through a CVD, PVD, or ALD process, but is not limited thereto. The low-k material layer may include a low-k material. The low-k material may include, for example, at least one of polymeric materials of a flowable oxide (FOX), a torene silazene (TOSZ), an undoped silicate glass (USG), a borosilicate glass (BSG), a phosphosilicate glass (PSG), a borophosphosilicate glass (BPSG), a plasma enhanced tetra ethyl ortho silicate (PETEOS), a fluoride silicate glass (FSG), a carbon doped silicon oxide (CDO), xerogel, aerogel, an amorphous fluorinated carbon, an organo silicate glass (OSG), parylene, a bis-benzocyclobutenes (BCB), SiLK, polyimide, a porous polymeric material, and a combination thereof, but is not limited thereto.

Next, the upper surface of the first gate insulating pattern material layer Gox1_L and the upper surface of the low-k material layer may be polished through a chemical mechanical polishing (CMP) process to form a preliminary first gate insulating pattern Gox1_P and a preliminary low-k material pattern 130_P.

The preliminary low-k material pattern 130_P may be disposed between the side surface of the first word line WL1 and the side surface of the second word line WL2. The preliminary low-k material pattern 130_P may be spaced apart from the side surface of the first word line WL1 and the side surface of the second word line WL2 by the preliminary first gate insulating pattern Gox1_P.

The preliminary low-k material pattern 130_P may be disposed on the first insulating pattern material layer 120_L. The preliminary low-k material pattern 130_P may be spaced apart from the upper surface of the first insulating pattern material layer 120_L by the preliminary first gate insulating pattern Gox1_P.

The preliminary low-k material pattern 130_P may be disposed on the preliminary first gate insulating pattern Gox1_P.

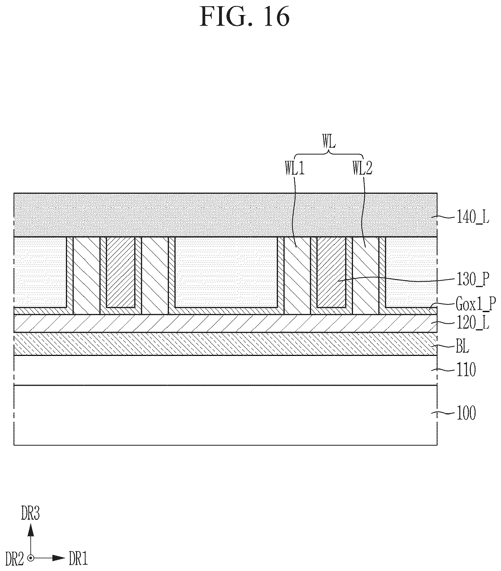

Referring to FIG. 16, a second insulating pattern material layer 140_L may be formed on the first word lines WL1 and the second word lines WL2. The second insulating pattern material layer 140_L may be deposited through a CVD, PVD, or ALD process, but is not limited thereto.

The second insulating pattern material layer 140_L may include or may be formed of at least one of silicon oxide, silicon oxynitride, silicon nitride, and a low-k material having a dielectric constant lower than that of silicon oxide, but is not limited thereto.

The second insulating pattern material layer 140_L may cover the upper surfaces of the first word lines WL1 and the second word lines WL2. The second insulating pattern material layer 140_L may cover the upper surface of the preliminary first gate insulating pattern Gox1_P covering the side surfaces of the first word lines WL1 and the second word lines WL2. The second insulating pattern material layer 140_L may cover the upper surface of the preliminary low-k material pattern 130_P.

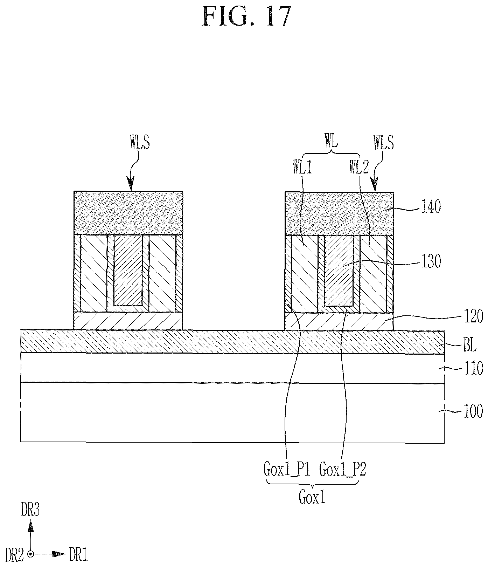

Referring to FIG. 17, the word line structures WLS including the first insulating pattern 120, the first word line WL1, the second word line WL2, the first gate insulating pattern Gox1, the low-k material pattern 130, and the second insulating pattern 140 may be formed.

The word line structures WLS may be formed by patterning the first insulating pattern material layer 120_L, the preliminary first gate insulating pattern Gox1_P, the preliminary low-k material pattern 130_P, and the second insulating pattern material layer 140_L. The word line structures WLS may extend in the second direction DR2, and may be spaced apart from each other in the first direction DR1.

The first word line WL1 and the second word line WL2 may be disposed between the upper surface of the first insulating pattern 120 and the lower surface of the second insulating pattern 140. The first word line WL1 may connect one portion of the upper surface of the first insulating pattern 120 and one portion of the lower surface of the second insulating pattern 140. The second word line WL2 may connect the other portion of the upper surface of the first insulating pattern 120 and the other portion of the lower surface of the second insulating pattern 140. The first word line WL1 and the second word line WL2 may be disposed to be spaced apart from each other in the first direction DR1 between the upper surface of the first insulating pattern 120 and the lower surface of the second insulating pattern 140.

The first gate insulating pattern Gox1 may cover the side surfaces of the first word line WL1 and the second word line WL2. The first gate insulating pattern Gox1 may include the first portion Gox1_P1 covering the side surfaces of the first word line WL1 and the second word line WL2 facing the outside of the word line structure WLS, and the second portion Gox1_P2 covering the side surfaces of the first word line WL1 and the second word line WL2 facing the inside of the word line structure WLS.

The first portion Gox1_P1 of the first gate insulating pattern Gox1 may form opposite side surfaces of the word line structure WLS. The second portion Gox1_P2 of the first gate insulating pattern Gox1 may cover the side surfaces of the first word line WL1 and the second word line WL2, which face each other. The second portion Gox1_P2 of the first gate insulating pattern Gox1 may cover the upper surface of the first insulating pattern 120 exposed between the side surfaces of the first word line WL1 and the second word line WL2 facing each other.

The low-k material pattern 130 may be disposed in the space surrounded by the upper surface of the first insulating pattern 120, the lower surface of the second insulating pattern 140, and the side surfaces of the first word line WL1 and the second word line WL2 facing each other. The second portion Gox1_P2 of the first gate insulating pattern Gox1 may be disposed between the side surfaces of the first word line WL 1 and the second word line WL2 facing each other and the low-k material pattern 130, and between the upper surface of the first insulating pattern 120 and the low-k material pattern 130. In other words, the low-k material pattern 130 may fill the space between the second portion Gox1_P2 of the first gate insulating pattern Gox1 and the second insulating pattern 140.

In some embodiments, instead of the low-k material layer in the processes of FIG. 15 to FIG. 17, a spin-on hardmask (SOH) layer may be deposited, and the spin-on hardmask layer may be removed through an ashing process after performing the processes of FIG. 15 to FIG. 17 to form an air gap instead of the low-k material pattern 130. Subsequently, by performing subsequent processes, the semiconductor device of the embodiment shown in FIG. 5 may be formed.

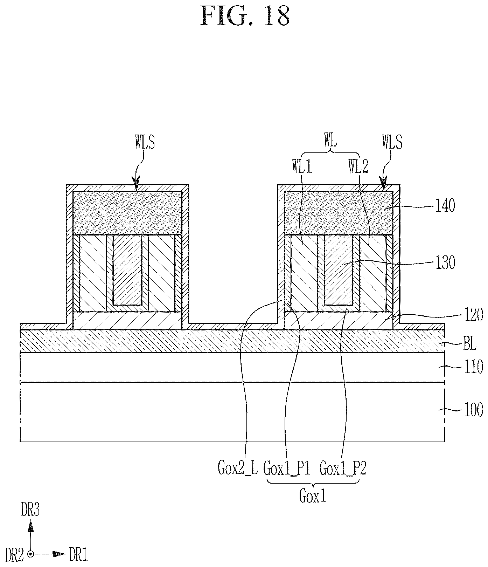

Referring to FIG. 18, the second gate insulating pattern material layer Gox2_L that conformally covers the word line structures WLS may be formed. The second gate insulating pattern material layer Gox2_L may be deposited through a CVD, PVD, or ALD process, but is not limited thereto.

The second gate insulating pattern material layer Gox2_L may include or may be formed of silicon oxide, silicon oxynitride, a high-k material with a higher dielectric constant than a silicon oxide, or a combination thereof. The high-k material may include a metal oxide or a metal oxynitride.

According to some embodiments, the second gate insulating pattern material layer Gox2_L may include a different type of material from the first gate insulating pattern Gox1. For example, the second gate insulating pattern material layer Gox2_L may include or may be formed of SiO₂.

The second gate insulating pattern material layer Gox2_L may cover the upper and side surfaces of the word line structures WLS. The second gate insulating pattern material layer Gox2_L may cover the upper surfaces of the bit lines BL exposed between the word line structures WLS and the upper surface of the lower insulating layer 110.

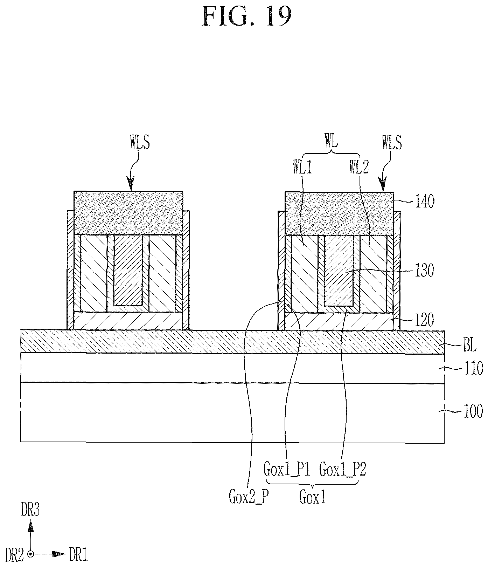

Referring to FIG. 19, the preliminary second gate insulating patterns Gox2_P may be formed by partially etching the second gate insulating pattern material layer Gox2_L. For example, through an anisotropic etching process, a portion of the second gate insulating pattern material layer Gox2_L disposed on the upper surfaces of the word line structures WLS, and a portion of the second gate insulating pattern material layer Gox2_L disposed on the upper surfaces of the bit lines BLs and the upper surface of the lower insulating layer 110 may be removed. The preliminary second gate insulating patterns Gox2_P may remain only on the side surfaces of the word line structures WLS. The preliminary second gate insulating patterns Gox2_P may extend in the second direction DR2 on the side surfaces of the word line structures WLS.

The preliminary second gate insulating pattern Gox2_P may extend from the upper surfaces of the bit lines BL in the third direction DR3. The preliminary second gate insulating pattern Gox2_P may extend in the third direction DR3 to cover the side surface of the word line structure WLS. The side surface of the word line structure WLS may include the side surface of the first insulating pattern 120, the side surface of the first portion Gox1_P1 of the first gate insulating pattern Gox1, and the side surface of the second insulating pattern 140. The preliminary second gate insulating pattern Gox2_P may cover the side surface of the first insulating pattern 120, the side surface of the first portion Gox1_P1 of the first gate insulating pattern Gox1, and the side surface of the second insulating pattern 140.

The upper surface of the preliminary second gate insulating pattern Gox2_P may be disposed at the same level as or a lower level than the upper surface of the second insulating pattern 140.

As shown in FIG. 19, the upper surface of the preliminary second gate insulating pattern Gox2_P may be disposed at a higher level than the upper surface of the first gate insulating pattern Gox1, but is not limited thereto. In some embodiments, the upper surface of the preliminary second gate insulating pattern Gox2_P may be disposed at the same level as the upper surface of the first gate insulating pattern Gox1.

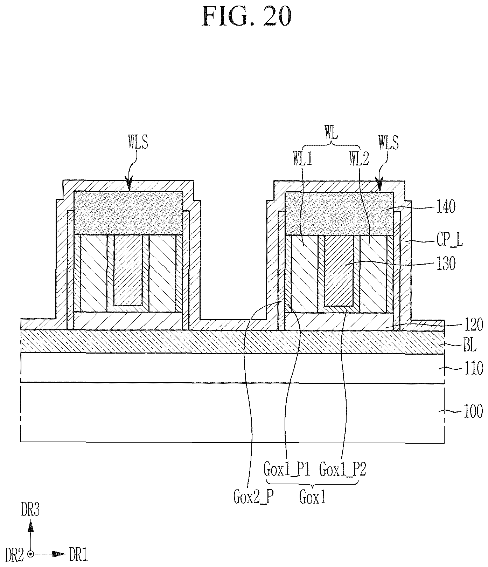

Referring to FIG. 20, a channel pattern material layer CP_L that is conformally cover the word line structures WLS in which the preliminary second gate insulating pattern Gox2_P is formed may be formed on opposite side surfaces of each word line structure WLS. The channel pattern material layer CP_L may be deposited through a CVD, PVD, or ALD process, but is not limited thereto.

In some embodiments, the channel pattern material layer CP_L may include or may be formed of an oxide semiconductor material. The oxide semiconductor material may include at least two or more of In, Ga, Zn, Al, Sn, and Hf, and the composition may further include materials such as Si, Mg, Ta, La, Nd, Ce, Sc, Cr, Co, Nb, Mo, Ba, Gd, Ti, W, Pd, Ru, Ni, Mn, and the like. For example, the oxide semiconductor material may include or may be IGZO.

For example, the channel pattern material layer CP_L may include or may be formed of IGZO.

The channel pattern material layer CP_L may cover the upper surface of the word line structure WLS. The channel pattern material layer CP_L may cover the side surface of the word line structure WLS. The channel pattern material layer CP_L may cover the upper surface and the side surface of the preliminary second gate insulating pattern Gox2_P. The channel pattern material layer CP_L may cover the upper surface of the bit lines BL exposed between the adjacent word line structures WLS and the upper surface of the lower insulating layer 110.

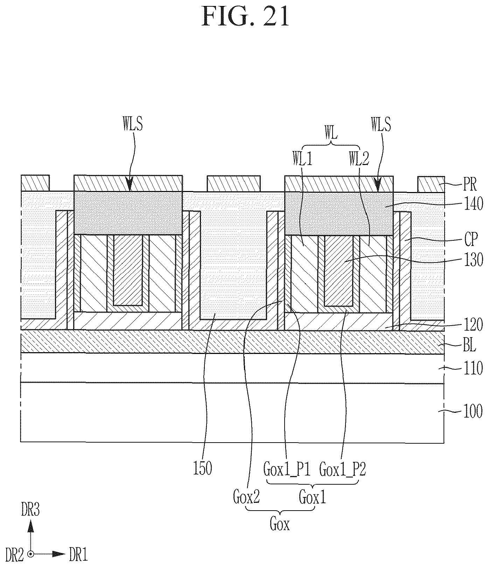

Referring to FIG. 21, the channel pattern material layer CP_L and the preliminary second gate insulating pattern Gox2_P may be patterned to form the channel pattern CP and the second gate insulating pattern Gox2.

First, the upper portion of the channel pattern material layer CP_L may be removed through an etch back process. For example, a portion of the channel pattern material layer CP_L covering the upper surface of the word line structure WLS and the upper surface of the preliminary second gate insulating pattern Gox2_P may be removed. For example, the upper surface of the channel pattern material layer CP_L may be etched until it is disposed at the same level as the upper surface of the preliminary second gate insulating pattern Gox2_P.

Subsequently, although not shown in a cross-sectional view taken along the first direction DR1 and the third direction DR3, the remaining channel pattern material layer CP_L and the preliminary second gate insulating pattern Gox2_P may be cut at regular intervals along the second direction DR2. Accordingly, a plurality of channel patterns CP and a plurality of second gate insulating patterns Gox2_P may be disposed to be spaced apart from each other in the first direction DR1, and may also be disposed to be spaced apart from each other in the second direction DR2.

The second gate insulating pattern Gox2 may extend from the upper surface of the bit line BL in the third direction DR3 to cover the side surface of the first insulating pattern 120, the side surface of the first portion Gox1_P1 of the first gate insulating pattern Gox1, and the side surface of the second insulating pattern 140.

The channel pattern CP may be spaced apart from the side surface of the word line structure WLS by the second gate insulating pattern Gox2. The channel pattern CP may be spaced apart from the word line WL by the second gate insulating pattern Gox2 and the first portion Gox1_P1 of the first gate insulating pattern Gox1.

The channel pattern CP may conformally cover the side surfaces of the second gate insulating patterns Gox2 disposed on the side surfaces of the adjacent word line structures WLS facing each other and the upper surface of the bit line BL exposed between the adjacent word line structures WLS. A portion of the channel pattern CP covering the side surface of the word line structure WLS (for example, the vertical portion CP_V of the channel pattern CP of FIG. 3) may extend in the third direction DR3. A portion of the channel pattern CP covering the upper surface of the bit line BL (for example, the horizontal portion CP_H of the channel pattern CP of FIG. 3) may extend in the first direction DR1. The channel pattern CP may have an approximately "U" shape in a cross-sectional view taken along the first and third directions DR1 and DR3.

Subsequently, the third insulating pattern 150 may be formed on the channel patterns CP. For example, after depositing the third insulating pattern material layer to a thickness covering the upper surface of the second insulating pattern 140, the third insulating pattern material layer may be polished through a CMP process to form the third insulating pattern 150. As illustrated in FIG. 21, the upper surface of the third insulating pattern 150 may be disposed at substantially the same level as the upper surface of the second insulating pattern 140, but is not limited thereto. When the upper surface of the third insulating pattern 150 is disposed at the same level as or a lower level than the upper surface of the second insulating pattern 140, the third insulating patterns 150 may be spaced apart from each other in the first direction DR1. For example, the third insulating patterns 150 may be disposed in a space between word line structures WLS adjacent to each other in the first direction DR1, and may be disposed to be spaced apart from each other in the first direction DR1.

The third insulating pattern 150 may fill the inside of the space surrounded by the U-shaped channel pattern CP. The third insulating pattern 150 may extend in the second direction DR2. The third insulating pattern 150 may fill the space between the channel patterns CP disposed to be spaced apart from each other in the second direction DR2. The third insulating pattern 150 may fill the space between the second gate insulating patterns Gox2 disposed to be spaced apart from each other in the second direction DR2.

The third insulating pattern 150 may cover the upper surfaces of the channel patterns CP and the upper surfaces of the second gate insulating patterns Gox2.

The third insulating pattern 150 may include or may be formed of a material having the same or similar etch selectivity as that of the second gate insulating pattern Gox2.

Subsequently, a photoresist pattern PR may be formed on the second insulating patterns 140 and the third insulating patterns 150. After a photoresist layer is formed on the upper surfaces of the second insulating patterns 140 and the upper surfaces of the third insulating patterns 150, it may be patterned to correspond to patterns of landing pads LP to be described later through exposure and development processes.

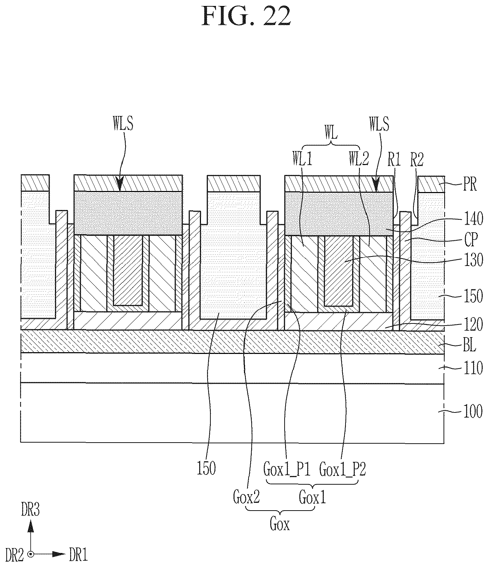

Referring to FIG. 22, the third insulating pattern 150 and the second gate insulating pattern Gox2 may be partially etched using the photoresist pattern PR as an etching mask.

As the upper portions of the third insulating pattern 150 and the second gate insulating pattern Gox2 are partially etched, the upper surface of the channel pattern CP and opposite side surfaces extending from the upper surface may be exposed.

By the etching process, the upper surface of the third insulating pattern 150 and the upper surface of the second gate insulating pattern Gox2 adjacent to the channel pattern CP may be lower than the upper surface of the channel pattern CP.

The upper surface of the second gate insulating pattern Gox2 may be disposed at a higher level than the upper surface of the first gate insulating pattern Gox1.

Through the etching process, a first recess R1 and a second recess R2 may be formed. A lower surface of the first recess R1 may be defined as the upper surface of the second gate insulating pattern Gox2. A sidewall of the first recess R1 may be defined as the side surface of the second insulating pattern 140 and one side surface of the channel pattern CP. A bottom surface of the second recess R2 may be defined as the upper surface of the third insulation pattern 150 adjacent to the channel pattern CP. A sidewall of the second recess R2 may be defined as the side surface of the third insulating pattern 150 and the other side surface of the channel pattern CP.

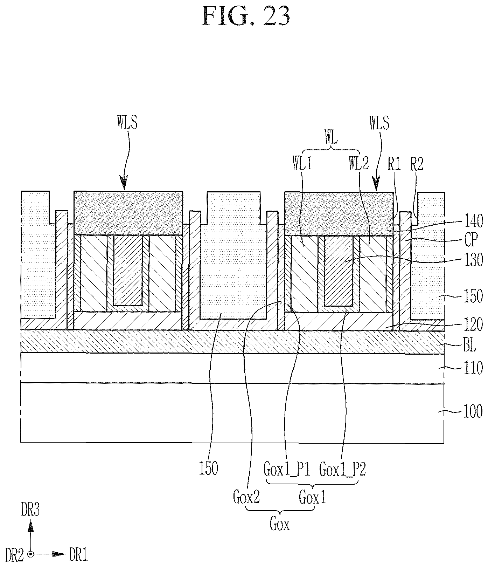

Referring to FIG. 23, the photoresist pattern PR may be removed. For example, the photoresist pattern PR may be removed through an ashing process and/or a strip process.

The channel pattern CP may be damaged by the etching process of FIG. 22. Accordingly, reliability may be improved by performing PN treatment on the channel pattern CP. The PN treatment may be performed before or after removing the photoresist pattern PR.

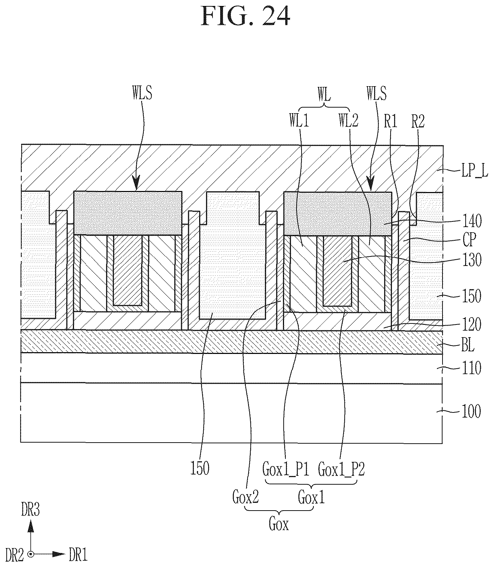

Referring to FIG. 24, the landing pad material layer LP_L may be formed. The landing pad material layer LP_L may be deposited through a CVD, PVD, or ALD process, but is not limited thereto.

The landing pad material layer LP_L may include or may be formed of doped polysilicon, metal, a conductive metal nitride, a conductive metal oxide, or a combination thereof. For example, the landing pad material layer LP_L may include or may be formed of Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOx, RuOx, or a combination thereof, but is not limited thereto.

The landing pad material layer LP_L may be formed to fill the first recess R1 and the second recess R2 and cover the upper surfaces of the second insulating patterns 140, the upper surfaces of the second gate insulating patterns Gox2, the upper surfaces of the channel patterns CPs, and the upper surfaces of the third insulating patterns 150.

The landing pad material layer LP_L may fill the first recess R1 and the second recess R2 and may be in contact with opposite side surfaces of the channel pattern CP. The landing pad material layer LP_L may fill a space between the side surface of the second insulating pattern 140 and the side surface of the third insulating pattern 150 at a higher level than the upper surface of the channel pattern CP, and may be in contact with the upper surface of the channel pattern CP.

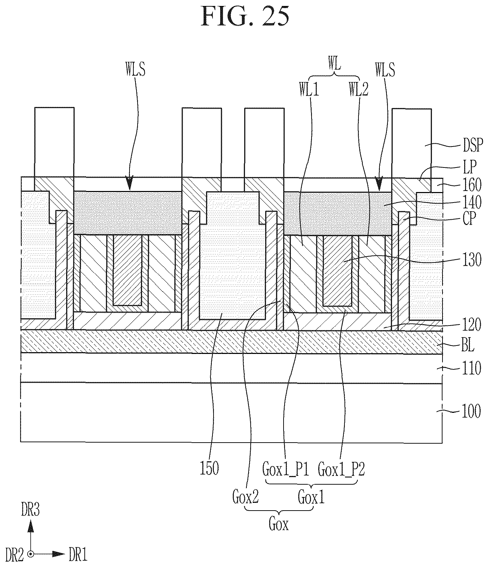

Referring to FIG. 25, after patterning the landing pad material layer LP_L to form holes exposing the upper surfaces of the second and third insulating patterns 140 and 150, the interlayer insulating layer 160 may be embedded in the holes, and then a planarization process may be performed. Accordingly, the landing pads LP may be formed. However, the order of forming the landing pads LP and the interlayer insulating layer 160 is not limited thereto.

In some embodiments, the interlayer insulating layer 160 may be formed and patterned on the upper surfaces of the second insulating patterns 140, the third insulating patterns 150, the second gate insulating patterns Gox2, and the channel patterns CP, and then the landing pads LP penetrating the interlayer insulating layer 160 may be formed.

The landing pad LP may be in contact with three surfaces of the channel pattern CP. The landing pad LP may be in contact with the upper surface of the channel pattern CP and opposite side surfaces extending from the upper surface.

For example, the landing pad LP may include a first portion disposed between the channel pattern CP and the third insulating pattern 150 (for example, the first portion LP_P1 of the landing pad LP in FIG. 4), a second portion disposed between the channel pattern CP and the second insulating pattern 140 (for example, the second portion LP_P2 of the landing pad LP in FIG. 4), and a connection portion connecting the first portion and the second portion (for example, the connection portion LP_C of the landing pad LP in FIG. 4). The connection portion of the landing pad LP may be in contact with the upper surface of the channel pattern CP. The first portion of the landing pad LP may be in contact with one side surface of the channel pattern CP extending from the upper surface of the channel pattern CP. The second portion of the landing pad LP may be in contact with the other side surface of the channel pattern CP extending from the upper surface of the channel pattern CP.

For example, the width of the upper surface of the landing pad LP (the length in the first direction DR1) may be greater than the width of the landing pad LP (the length in the first direction DR1) between the second insulating pattern 140 and the third insulating pattern 150, but is not limited thereto.

Subsequently, the data storage patterns DSP may be formed on the upper surfaces of the landing pads LP, respectively. In some embodiments, the data storage pattern DSP may be a capacitor including a lower electrode, a capacitor dielectric film, and an upper electrode, and in this case, the lower electrode may be in contact with the landing pad LP.

In some embodiments, the processes of FIG. 18 and FIG. 19 may be omitted, and the processes of FIG. 20 to FIG. 25 may be performed after the process of FIG. 17. In this case, the second gate insulating pattern Gox2 is not formed, and the channel pattern CP may be formed directly on opposite side surfaces of the word line structures WLS. The channel pattern CP may be formed to further cover a portion of the upper surface of the second insulating pattern 140. The third insulating pattern 150 may be formed not only on the channel pattern CP but also on the second insulating pattern 140.

The landing pad LP may include a first portion disposed between a portion of the third insulating pattern 150 formed on the channel pattern CP and the channel pattern CP, a second portion disposed between a portion of the third insulating pattern 150 formed on the second insulating pattern 140 and the channel pattern CP, and a connection portion connecting the first portion and the second portion. The lower surface of the first portion may be in contact with the third insulating pattern 150, and the lower surface of the second portion may be in contact with the second insulating pattern 140.

The landing pad LP may be in contact with the upper surface of the channel pattern CP and opposite side surfaces extending from the upper surface. The connection portion may be in contact with the upper surface of the channel pattern CP. The first portion may be in contact with one side surface of the channel pattern CP facing the portion of the third insulating pattern 150 formed on the channel pattern CP. The second portion may be in contact with the other side surface of the channel pattern CP facing the portion of the third insulating pattern 150 formed on the second insulating pattern 140.

Accordingly, the semiconductor device of the embodiment shown in FIG. 8 may be formed.

While the embodiment of the present disclosure has been described in connection with what is presently considered to be practical embodiments, it is to be understood that the disclosure is not limited to the disclosed embodiments, but, on the contrary, is intended to cover various modifications and equivalent arrangements included within the scope of the appended claims.

## Claims

1. A semiconductor device comprising:
a substrate (100);
a bit line (BL) disposed on the substrate (100) and extending in a first direction (DR1);
a first insulating pattern (120) disposed on an upper surface of the bit line (BL) and extending in a second direction (DR2) intersecting the first direction (DR1), wherein the first direction (DR1) and the second direction (DR2) are parallel to an upper surface of the substrate (100);
a first word line (WL1) disposed on an upper surface of the first insulating pattern (120) and extending in the second direction (DR2);
a channel pattern (CP) disposed on the upper surface of the bit line (BL) and spaced apart from the first word line (WL1) in the first direction (DR1);
a gate insulating pattern (Gox) disposed between a first side surface of the first word line (WL1) and the channel pattern (CP);
a second insulating pattern (140) disposed on an upper surface of the first word line (WL1) and extending in the second direction (DR2);
a third insulating pattern (150) disposed on the channel pattern (CP), wherein the channel pattern (CP) includes a horizontal portion (CP_H) and a vertical portion (CP_V),
wherein the horizontal portion (CP_H) extends along the first direction (DR1) and is interposed between the upper surface of the bit line (BL) and a lower surface of the third insulating pattern (150),
wherein the vertical portion (CP_V) extends from the horizontal portion (CP_H) along a third direction (DR3) and is interposed between a side surface of the third insulating pattern (150) and the first word line (WL1), and
wherein the third direction (DR3) is perpendicular to the upper surface of the substrate (100); and
a landing pad (LP) connected to the channel pattern (CP) and covering an upper surface of the vertical portion (CP_V) of the channel pattern (CP) and opposite side surfaces of the vertical portion (CP_V) extending from the upper surface of the vertical portion (CP_V).

2. The semiconductor device of claim 1,
wherein the landing pad (LP) includes:
a first portion (LP_P1) disposed between the third insulating pattern (150) and the channel pattern (CP),
a second portion (LP _P2) disposed between the channel pattern (CP) and the second insulating pattern (140), and
a connection portion (LP_C) connecting the first portion (LP_P1) to the second portion (LP _P2) and covering an upper surface of the channel pattern (CP).

3. The semiconductor device of claim 2,
wherein the gate insulating pattern (Gox) includes:
a first gate insulating pattern (Gox1) contacting the first side surface of the first word line (WL1), and
a second gate insulating pattern (Gox2) disposed between the first gate insulating pattern (Gox1) and the vertical portion (CP_V) of the channel pattern (CP), and
wherein the second portion (LP _P2) of the landing pad (LP) covers an upper surface of the second gate insulating pattern (Gox2).

4. The semiconductor device of claim 3,
wherein the upper surface of the second gate insulating pattern (Gox2) is disposed at the same level as or a higher level than an upper surface of the first gate insulating pattern (Gox 1).

5. The semiconductor device of claim 3 or 4, further comprising:
a second word line (WL2) disposed on the upper surface of the first insulating pattern (120) and extending in the second direction (DR2), wherein the second word line (WL2) is spaced apart from the first word line (WL1) in the first direction (DR1), wherein the first word line (WL1) and the second word line (WL2) are disposed between the upper surface of the first insulating pattern (120) and a lower surface of the second insulating pattern (140),
wherein the first gate insulating pattern (Gox1) includes:
a first portion (Gox1_P1) contacting the first side surface of the first word line (WL1) facing the channel pattern (CP) and a first side surface of the second word line (WL2) facing the channel pattern (CP), and
a second portion (Gox1_P2) contacting a second side surface, opposite to the first side surface, of the first word line (WL1) and a second side surface, opposite to the first side surface, of the second word line (WL2), and
wherein the second side surface of the first word line (WL1) and the second side surface of the second word line (WL2) are adjacent to each other and are disposed between the first side surface of the first word line (WL1) and the first side surface of the second word line (WL2).

6. The semiconductor device of claim 5, further comprising:
a low dielectric constant, low-k, material (130) filling a space between the second portion (Gox1_P2) of the first gate insulating pattern (Gox1) and the lower surface of the second insulating pattern (140).

7. The semiconductor device of claim 5,
wherein an air-gap (130A) is disposed in a space between the second portion (Gox1_P2) of the first gate insulating pattern (Gox1) and the lower surface of the second insulating pattern (140).

8. The semiconductor device of any one of claims 1 to 4, further comprising:
a second word line (WL2) disposed on the upper surface of the first insulating pattern (120) and extending in the second direction (DR2), wherein the second word line (WL2) is spaced apart from the first word line (WL1) in the first direction (DR1),
wherein the first word line (WL1) contacts the upper surface of the first insulating pattern (120) and a lower surface of the second insulating pattern (140),
wherein the second word line (WL2) contacts the upper surface of the first insulating pattern (120) and the lower surface of the second insulating pattern (140), and
wherein a space (130) defined by the upper surface of the first insulating pattern (120), the lower surface of the second insulating pattern (140), and side surfaces of the first word line (WL1) and the second word line (WL2) facing each other is filled with a low-k material.

9. The semiconductor device of any one of claims 1 to 4, further comprising:
a second word line (WL2) disposed on the upper surface of the first insulating pattern (120) and extending in the second direction (DR2), wherein the second word line (WL2) is spaced apart from the first word line (WL1) in the first direction (DR1),
wherein the first word line (WL1) connects one portion of the upper surface of the first insulating pattern (120) to one portion of a lower surface of the second insulating pattern (140),
wherein the second word line (WL2) connects the other portion of the upper surface of the first insulating pattern (120) to the other portion of the lower surface of the second insulating pattern (140), and
wherein an air gap (130A) is disposed in a space defined by the upper surface of the first insulating pattern (120), the lower surface of the second insulating pattern (140), and side surfaces of the first word line (WL1) and the second word line (WL2) facing each other.

10. The semiconductor device of claim 1,
wherein the channel pattern (CP) further extends to cover an upper surface of the second insulating pattern (140), and
wherein the third insulating pattern (150) is further disposed on the second insulating pattern (140).

11. The semiconductor device of claim 10,
wherein the landing pad (LP) includes:
a first portion (LP_P1) and a second portion (LP _P2) disposed between the third insulating pattern (150) and the channel pattern (CP), and
a connection portion (LP_C) connecting the first portion (LP_P1) and the second portion (LP _P2) and covering an upper surface of the channel pattern (CP),
wherein a lower surface of the first portion (LP_P1) contacts the third insulating pattern (150), and
wherein a lower surface of the second portion (LP _P2) contacts the second insulating pattern (140).

12. The semiconductor device of claim 2 to 10,
wherein a lower surface of the first portion (LP_P1) of the landing pad (LP) contacts the third insulating pattern (150), and
wherein a lower surface of the second portion (LP _P2) of the landing pad (LP) contacts the gate insulating pattern (Gox).

13. The semiconductor device of claim 2 to 10,
wherein the lower surface of the first portion (LP_P1) of the landing pad (LP) contacts the third insulating pattern (150), and
wherein the lower surface of the second portion (LP _P2) of the landing pad (LP) contacts the second insulating pattern (140).

14. The semiconductor device of claim 5, further comprising:
a low-k material pattern (130) disposed in a space between the second portion (Gox1_P2) of the first gate insulating pattern (Gox1) and the lower surface of the second insulating pattern (140),
wherein the first gate insulating pattern (Gox1) is further disposed between the low-k material pattern (130) and the first word line (WL1), between the low-k material pattern (130) and the second word line (WL2), and between the low-k material pattern (130) and the first insulating pattern (120).

15. The semiconductor device of claim 7,
wherein the first gate insulating pattern (Gox1) is further disposed between the air gap (130A) and the first word line (WL1), between the air gap (130A) and the second word line (WL2), and between the air gap (130A) and the first insulating pattern (120).

## Amended claims

### Amended claims in accordance with Rule 137(2) EPC.

1. A semiconductor device comprising:
a substrate (100);
a bit line (BL) disposed on the substrate (100) and extending in a first direction (DR1);
a first insulating pattern (120) disposed on an upper surface of the bit line (BL) and extending in a second direction (DR2) intersecting the first direction (DR1), wherein the first direction (DR1) and the second direction (DR2) are parallel to an upper surface of the substrate (100);
a first word line (WL1) disposed on an upper surface of the first insulating pattern (120) and extending in the second direction (DR2);
a channel pattern (CP) disposed on the upper surface of the bit line (BL) and spaced apart from the first word line (WL1) in the first direction (DR1);
a gate insulating pattern (Gox) disposed between a first side surface of the first word line (WL1) and the channel pattern (CP);
a second insulating pattern (140) disposed on an upper surface of the first word line (WL1) and extending in the second direction (DR2);
a third insulating pattern (150) disposed on the channel pattern (CP), wherein the channel pattern (CP) includes a horizontal portion (CP_H) and a vertical portion (CP_V),
wherein the horizontal portion (CP_H) extends along the first direction (DR1) and is interposed between the upper surface of the bit line (BL) and a lower surface of the third insulating pattern (150),
wherein the vertical portion (CP_V) extends from the horizontal portion (CP_H) along a third direction (DR3) and is interposed between a side surface of the third insulating pattern (150) and the first word line (WL1), and
wherein the third direction (DR3) is perpendicular to the upper surface of the substrate (100); and
a landing pad (LP) connected to the channel pattern (CP) and covering an upper surface of the vertical portion (CP_V) of the channel pattern (CP) and opposite side surfaces of the vertical portion (CP_V) extending from the upper surface of the vertical portion (CP_V),
wherein the landing pad (LP) includes:
a first portion (LP_P1) disposed between the third insulating pattern (150) and the channel pattern (CP),
a second portion (LP_P2) disposed between the channel pattern (CP) and the second insulating pattern (140), and
a connection portion (LP_C) connecting the first portion (LP_P1) to the second portion (LP_P2) and covering an upper surface of the channel pattern (CP),
wherein the gate insulating pattern (Gox) includes:
a first gate insulating pattern (Gox1) contacting the first side surface of the first word line (WL1), and
a second gate insulating pattern (Gox2) disposed between the first gate insulating pattern (Gox1) and the vertical portion (CP_V) of the channel pattern (CP), and
wherein the second portion (LP_P2) of the landing pad (LP) covers an upper surface of the second gate insulating pattern (Gox2).

2. The semiconductor device of claim 1,
wherein the upper surface of the second gate insulating pattern (Gox2) is disposed at the same level as or a higher level than an upper surface of the first gate insulating pattern (Gox1).

3. The semiconductor device of claim 1 or 2, further comprising:
a second word line (WL2) disposed on the upper surface of the first insulating pattern (120) and extending in the second direction (DR2), wherein the second word line (WL2) is spaced apart from the first word line (WL1) in the first direction (DR1), wherein the first word line (WL1) and the second word line (WL2) are disposed between the upper surface of the first insulating pattern (120) and a lower surface of the second insulating pattern (140),
wherein the first gate insulating pattern (Gox1) includes:
a first portion (Gox1_P1) contacting the first side surface of the first word line (WL1) facing the channel pattern (CP) and a first side surface of the second word line (WL2) facing the channel pattern (CP), and
a second portion (Gox1_P2) contacting a second side surface, opposite to the first side surface, of the first word line (WL1) and a second side surface, opposite to the first side surface, of the second word line (WL2), and
wherein the second side surface of the first word line (WL1) and the second side surface of the second word line (WL2) are adjacent to each other and are disposed between the first side surface of the first word line (WL1) and the first side surface of the second word line (WL2).

4. The semiconductor device of claim 3, further comprising:
a low dielectric constant, low-k, material (130) filling a space between the second portion (Gox1_P2) of the first gate insulating pattern (Gox1) and the lower surface of the second insulating pattern (140).

5. The semiconductor device of claim 3,
wherein an air-gap (130A) is disposed in a space between the second portion (Gox1_P2) of the first gate insulating pattern (Gox1) and the lower surface of the second insulating pattern (140).

6. The semiconductor device of claim 1 or 2, further comprising:
a second word line (WL2) disposed on the upper surface of the first insulating pattern (120) and extending in the second direction (DR2), wherein the second word line (WL2) is spaced apart from the first word line (WL1) in the first direction (DR1),
wherein the first word line (WL1) contacts the upper surface of the first insulating pattern (120) and a lower surface of the second insulating pattern (140),
wherein the second word line (WL2) contacts the upper surface of the first insulating pattern (120) and the lower surface of the second insulating pattern (140), and
wherein a space (130) defined by the upper surface of the first insulating pattern (120), the lower surface of the second insulating pattern (140), and side surfaces of the first word line (WL1) and the second word line (WL2) facing each other is filled with a low-k material.

7. The semiconductor device of claim 1 or 2, further comprising:
a second word line (WL2) disposed on the upper surface of the first insulating pattern (120) and extending in the second direction (DR2), wherein the second word line (WL2) is spaced apart from the first word line (WL1) in the first direction (DR1),
wherein the first word line (WL1) connects one portion of the upper surface of the first insulating pattern (120) to one portion of a lower surface of the second insulating pattern (140),
wherein the second word line (WL2) connects the other portion of the upper surface of the first insulating pattern (120) to the other portion of the lower surface of the second insulating pattern (140), and
wherein an air gap (130A) is disposed in a space defined by the upper surface of the first insulating pattern (120), the lower surface of the second insulating pattern (140), and side surfaces of the first word line (WL1) and the second word line (WL2) facing each other.

8. A semiconductor device comprising:
a substrate (100);
a bit line (BL) disposed on the substrate (100) and extending in a first direction (DR1);
a first insulating pattern (120) disposed on an upper surface of the bit line (BL) and extending in a second direction (DR2) intersecting the first direction (DR1), wherein the first direction (DR1) and the second direction (DR2) are parallel to an upper surface of the substrate (100);
a first word line (WL1) disposed on an upper surface of the first insulating pattern (120) and extending in the second direction (DR2);
a channel pattern (CP) disposed on the upper surface of the bit line (BL) and spaced apart from the first word line (WL1) in the first direction (DR1);
a gate insulating pattern (Gox) disposed between a first side surface of the first word line (WL1) and the channel pattern (CP);
a second insulating pattern (140) disposed on an upper surface of the first word line (WL1) and extending in the second direction (DR2);
a third insulating pattern (150) disposed on the channel pattern (CP), wherein the channel pattern (CP) includes a horizontal portion (CP_H) and a vertical portion (CP_V),
wherein the horizontal portion (CP_H) extends along the first direction (DR1) and is interposed between the upper surface of the bit line (BL) and a lower surface of the third insulating pattern (150),
wherein the vertical portion (CP_V) extends from the horizontal portion (CP_H) along a third direction (DR3) and is interposed between a side surface of the third insulating pattern (150) and the first word line (WL1), and
wherein the third direction (DR3) is perpendicular to the upper surface of the substrate (100); and
a landing pad (LP) connected to the channel pattern (CP) and covering an upper surface of the vertical portion (CP_V) of the channel pattern (CP) and opposite side surfaces of the vertical portion (CP_V) extending from the upper surface of the vertical portion (CP_V); and
wherein the channel pattern (CP) further extends to cover an upper surface of the second insulating pattern (140), and
wherein the third insulating pattern (150) is further disposed on the second insulating pattern (140).

9. The semiconductor device of claim 8,
wherein the landing pad (LP) includes:
a first portion (LP_P1) and a second portion (LP_P2) disposed between the third insulating pattern (150) and the channel pattern (CP), and
a connection portion (LP_C) connecting the first portion (LP_P1) and the second portion (LP_P2) and covering an upper surface of the channel pattern (CP),
wherein a lower surface of the first portion (LP_P1) contacts the third insulating pattern (150), and
wherein a lower surface of the second portion (LP_P2) contacts the second insulating pattern (140).

10. The semiconductor device of any one of claims 1 to 8,
wherein a lower surface of the first portion (LP_P1) of the landing pad (LP) contacts the third insulating pattern (150), and
wherein a lower surface of the second portion (LP_P2) of the landing pad (LP) contacts the gate insulating pattern (Gox).

11. The semiconductor device of any one of claims 1 to 8,
wherein the lower surface of the first portion (LP_P1) of the landing pad (LP) contacts the third insulating pattern (150), and
wherein the lower surface of the second portion (LP_P2) of the landing pad (LP) contacts the second insulating pattern (140).

12. The semiconductor device of claim 3, further comprising:
a low-k material pattern (130) disposed in a space between the second portion (Gox1_P2) of the first gate insulating pattern (Gox1) and the lower surface of the second insulating pattern (140),
wherein the first gate insulating pattern (Gox1) is further disposed between the low-k material pattern (130) and the first word line (WL1), between the low-k material pattern (130) and the second word line (WL2), and between the low-k material pattern (130) and the first insulating pattern (120).

13. The semiconductor device of claim 5,
wherein the first gate insulating pattern (Gox1) is further disposed between the air gap (130A) and the first word line (WL1), between the air gap (130A) and the second word line (WL2), and between the air gap (130A) and the first insulating pattern (120).
